(19) Europäisches Patentamt
European Patent Office
Office européen des brevets

(11) **EP 4 707 821 A1**

(12) **EUROPEAN PATENT APPLICATION**

(43) Date of publication:
**11.03.2026 Bulletin 2026/11**

(21) Application number: **25197126.3**

(22) Date of filing: **20.08.2025**

(51) International Patent Classification (IPC):
**G01R 15/20** *(2006.01)*    **G01R 33/00** *(2006.01)*
**G01R 33/07** *(2006.01)*    **G01R 33/09** *(2006.01)*

(52) Cooperative Patent Classification (CPC):
**G01R 15/205; G01R 33/0005; G01R 33/07;
G01R 33/098;** G01R 15/207

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **03.09.2024 US 202418822765**

(71) Applicant: **Allegro MicroSystems, LLC
Manchester, NH 03103 (US)**

(72) Inventors:
• **KASPAREK, Christian
69124 Heidelberg (DE)**
• **SHEWMON, Nathan
38114 Braunschweig (DE)**

(74) Representative: **South, Nicholas Geoffrey et al
Venner Shipley LLP
200 Aldersgate
London EC1A 4HD (GB)**

(54) **SYSTEMS, METHODS, AND STRUCTURES FOR REDUCING CONDUCTOR CROSS-TALK
ERROR**

(57) Disclosed are example systems, methods, and structures for reducing conductor cross-talk error. In particular, disclosed is an example conductor structure that can conduct current and that accommodates placement of a current sensor device. The systems, methods, and structures disclosed herein may allow for multiple example conductor structures to be placed in proximity to each other, and may allow a current sensor device to measure an amount of current flowing in one of the conductor structures, while reducing the impact of any current flowing in a neighboring conductor structure on the measurement of the current sensor device. Also disclosed herein are example methods for making such a conductor structure. Further disclosed herein are example systems that incorporate both such an example conductor structure and a current sensor device, and example methods for configuring a current sensor system including both such an example conductor structure and current sensor device.

EP 4 707 821 A1

## Description

## BACKGROUND

Sensors are used to perform various functions in a variety of applications. Some sensors include one or more magnetic field sensing elements, such as a Hall effect element or a magnetoresistive element, to sense a magnetic field associated with proximity or motion of a target object, such as a ferromagnetic object in the form of a gear or a ring magnet, or to sense a current in a conductor, as some examples. Integrated circuits (ICs) incorporating sensors are widely used in automobile control systems and other safety-critical applications.

## SUMMARY

Disclosed are example systems, methods, and structures for reducing conductor cross-talk error. In particular, disclosed is a conductor structure that can conduct current and that accommodates placement of a current sensor device. The systems, methods, and structures disclosed herein may allow for multiple conductor structures to be placed in proximity to each other, and may allow a current sensor device to measure an amount of current flowing in one of the conductor structures, while reducing the impact of any current flowing in a neighboring conductor structure on the measurement of the current sensor device. Also disclosed herein are methods for making such a conductor structure. Further disclosed herein are systems that incorporate both such a conductor structure and a current sensor device, and methods for configuring a current sensor system including both such a conductor structure and current sensor device.

In accordance with some embodiments, there is provided a system. The system comprises a conductor structure having a width along a first dimension and a length longer than the width along a second dimension. The conductor structure comprises a first portion of the conductor structure defining a hole passing through the conductor structure. The conductor structure also comprises a second portion of the conductor structure defining a first notch out of a first side of the conductor structure. The conductor structure further comprises a third portion of the conductor structure defining a second notch out of a second side of the conductor structure. The system further comprises a sensor device positioned in the hole, the sensor device comprising first and second magnetic field sensing elements configured to be sensitive to a magnetic field along the second dimension when current flows through the conductor structure.

In some embodiments, at least one of the first and second magnetic field sensing elements is one of a Hall plate element or a tunneling magnetoresistance (TMR) element.

In further embodiments, the first and second magnetic field sensing elements are Hall plate elements.

In still further embodiments, the hole is at least partially defined by a first edge of the first portion along the first dimension and a second edge of the first portion along the second dimension.

In some embodiments, the first edge is longer than the second edge.

In further embodiments, the first notch passes through the conductor structure.

In still further embodiments, each of the first notch and the second notch passes through the conductor structure.

In some embodiments, the first notch is at least partially defined by a first edge of the second portion along the second dimension.

In further embodiments, the second notch is at least partially defined by a first edge of the third portion along the second dimension.

In still further embodiments, the hole is at least partially defined by parallel bars of the conductor structure along the first dimension.

In some embodiments, the hole is at least partially defined by parallel bars of the conductor structure along the second dimension.

In further embodiments, the first portion, second portion, and third portion together form an S-shape.

In still further embodiments, the conductor structure is a first conductor structure having a first width and a first length, and the sensor device is a first sensor device. The system further comprises a second conductor structure having a second width along the first dimension and a second length along the second dimension, the second conductor structure defining a second hole passing through the second conductor structure. The system still further comprises a second sensor device positioned in the second hole.

In some embodiments, the system comprises a third conductor structure having a third width along the first dimension and a third length along the second dimension, the third conductor structure defining a third hole passing through the third conductor structure. The system also comprises a third sensor device positioned in the third hole.

In further embodiments, a first surface of the first conductor structure is parallel with a first surface of the second conductor structure.

In still further embodiments, the first conductor structure is configured to transmit a first alternating current, the second conductor structure is configured to transmit a second alternating current that is phase-shifted from the first alternating current, and the third conductor structure is configured to transmit a third alternating current that is phase-shifted from the first alternating current and that is phase-shifted from the second alternating current.

In some embodiments, the conductor structure is a bus bar.

Furthermore, in accordance with some embodiments, there is provided a method of configuring a current sensor system. The method comprises coupling a conductor structure to a power source and a load, the conductor structure having a width along a first dimension and a length along a second dimension. The conductor structure further defines a hole passing through the conductor structure, a first notch out of a first side of the conductor structure, and a second notch out of a second side of the conductor structure. The method also comprises inserting a sensor device into the hole such that first and second magnetic field sensing elements of the sensor device are configured to be sensitive to a magnetic field along the second dimension when current is flowing through the conductor structure.

In some embodiments, the conductor structure is a first structure, and the sensor device is a first sensor device, and the method further comprises coupling a second conductor structure to the power source and the load. The second conductor structure has a hole passing through the second conductor structure, a first notch out of a first side of the second conductor structure, and a second notch out of a second side of the second conductor structure. The method still further comprises inserting a second sensor device into the hole of the second conductor structure such that first and second magnetic field sensing elements of the second sensor device are configured to be sensitive to a magnetic field along the second dimension when current is flowing through the second conductor structure.

Additionally, in accordance with some embodiments, there is provided a conductor structure having a width along a first dimension and a length longer than the width along a second dimension. The conductor structure comprises a first portion that defines a hole passing through the conductor structure, the hole being at least partially defined by a first edge along the first dimension and a second edge along the second dimension, the first edge being longer than the second edge. The conductor structure also comprises a second portion defining a first notch out of a first side of the conductor structure. The conductor structure further comprises a third portion defining a second notch out of a second side of the conductor structure.

Moreover, in accordance with some embodiments, there is provided a method of making a conductor structure. The method comprises receiving a piece of conductive material, and forming a hole out of the conductive material. The method also comprises forming a first notch out of the conductive material, the first notch being formed out of a first side of the conductive material. The method further comprises forming a second notch out of the conductive material, the second notch being formed out of a second side of the conductive material.

In further embodiments, the hole, first notch, and second notch are formed by stamping the hole, first notch, and second notch out of the piece of conductive material.

In some embodiments, the hole, first notch, and second notch are formed by melting the piece of conductive material and pouring the molten conductive material into a mold.

Before explaining example embodiments consistent with the present disclosure in detail, it is to be understood that the disclosure is not limited in its application to the details of constructions and to the arrangements set forth in the following description or illustrated in the drawings. The disclosure is capable of being practiced and carried out in various ways. Also, it is to be understood that the phraseology and terminology employed herein, as well as in the abstract, are for the purpose of description and should not be regarded as limiting.

It is to be understood that both the foregoing general description and the following detailed description are explanatory only and are not restrictive of the claimed subject matter.

## BRIEF DESCRIPTION OF THE DRAWINGS

The accompanying drawings are incorporated in and constitute part of this specification. The drawings, together with the description, illustrate and serve to explain the principles of various example embodiments of the disclosure.

FIG. 1 is a diagram of an example system in which currents in conductors are measured.

FIG. 2 is a diagram of an example system for measuring current in a conductor.

FIG. 3 is another diagram of an example system for measuring current in a conductor.

FIG. 4 is a diagram of an example current sensor device.

FIG. 5A is a diagram of another example system for measuring a current in a conductor.

FIG. 5B is a diagram of another view of the example system for measuring current in a conductor of FIG. 5A.

FIG. 5C is a diagram of an example current sensor device for measuring current in a conductor.

FIG. 6A is a diagram of a system with an arrangement of two example conductor structures positioned in proximity to one another.

FIG. 6B is a diagram of a system with another arrangement of two example conductor structures positioned in proximity to one another.

FIG. 7 is a diagram of a system with an arrangement of another two example conductor structures positioned in proximity to one another.

FIG. 8A is a diagram of an example conductor structure, consistent with embodiments of the present disclosure.

FIG. 8B is another diagram of the example conductor structure of FIG. 8A, consistent with embodiments of the present disclosure.

FIG. 9A is a diagram of an example system including the example conductor structure of FIGs. 8A and 8B and a current sensor device, consistent with embodiments of the present disclosure.

FIG. 9B is a diagram of an arrangement of two example conductor structures positioned in proximity to one another, consistent with embodiments of the present disclosure.

FIG. 9C is a diagram of a system including three example conductor structures positioned in proximity to one another, and with three current sensor devices, each of the current sensor devices positioned to sense current in a respective conductor structure, consistent with embodiments of the present disclosure.

FIG. 10A is a diagram of a close-up view of a portion of the system of FIG. 9A.

FIG. 10B is a diagram of close-up view of a current sensor device positioned within a system.

FIG. 11A is a graph with a plot representing a magnetic field in a plane around a current sensor device positioned in proximity to the example conductor structure of FIGs. 8A and 8B.

FIG. 11B is a diagram showing a plot representing a magnetic field in a plane when current is flowing in one example conductor structure in an arrangement of example conductor structures.

FIG. 12 is a graph showing a cross-talk error associated with different systems using different example conductor structures.

FIG. 13 is an example process for configuring a system including an example conductor structure and an example current sensor device, consistent with embodiments of the present disclosure.

FIG. 14 is an example process for making an example conductor structure, consistent with embodiments of the present disclosure.

The drawings are not necessarily to scale, or inclusive of all elements of a system, emphasis instead generally being placed upon illustrating the concepts, structures, and techniques sought to be protected herein.

## DETAILED DESCRIPTION

Reference will now be made in detail to the embodiments of the disclosure, certain examples of which are illustrated in the accompanying drawings.

In the following description, numerous specific details are set forth regarding the systems, methods, and structures of the disclosed subject matter, and the environment in which such systems, methods, and structures operate, to provide a thorough understanding of the disclosed subject matter. After reading the descriptions provided herein, it will be apparent to one skilled in the art, however, that the disclosed subject matter may be practiced without such specific details. It will also be apparent to one skilled in the art that certain features, which are well known within the art, are not described in detail to avoid unnecessary complication of the description of the systems, methods, and structures described herein. In addition, it will be understood that the embodiments provided below are examples, and that it is contemplated that there are other systems, methods, and structures that are within the scope of the subject matter disclosed herein.

Electric vehicles (EVs) may include one or more alternating current (AC) motors. EVs may also include a traction inverter or power module, which is a power electronics device/system that converts a direct current (DC) supply of power from one or more vehicle batteries to an AC output and that controls a flow of current for use by the vehicle's one or more electric motors. The AC output may then be used to power the electric motor(s), providing drive for the vehicle. Traction inverters are sometimes referred to as variable frequency drives, motor drives, traction drives, and variable speed drives. Traction inverters typically include semiconductor switches such as power transistors, for example, insulated-gate bipolar transistors (IGBTs), silicon carbide (SiC) metal oxide field effect transistors (MOSFETs), or gallium nitride (GaN) MOSFETs, which are controlled by controllers, typically referred to as gate drivers. In electric and hybrid vehicles, the electric motor may also act as a generator during regenerative braking, converting the vehicle's kinetic energy into AC power. This AC power may then be converted to DC power by the traction inverter, allowing the battery to be charged. The gate drivers and associated power transistors of a traction inverter (power module), when considered together, are commonly referred to as power converters. A power converter may be an inverter type (e.g., changing AC power to DC power, and vice versa) or a converter type (e.g., changing DC power at one voltage and/or current to DC power at another voltage and/or current). Power converters may include six power transistors for rectification for three-phase EV motors.

In order to accurately measure current flowing in the power module, a current sensor device comprising magnetic field sensing elements may be used. The current sensor device may measure current flowing in a conductor, such as in a bus bar (e.g., a conductive metallic strip or bar), of the power module.

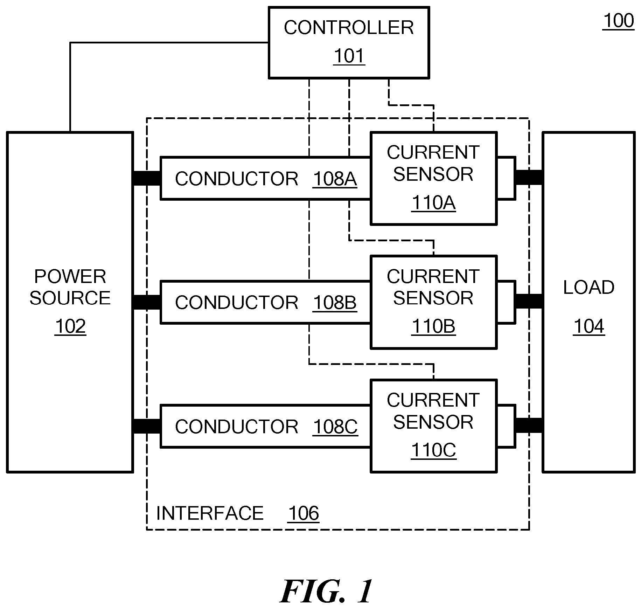

FIG. 1 is a diagram of an example system 100 in which currents in conductor structures are measured. System 100 may, for example, be used in an EV to provide power from a power source 102 (e.g., battery) to a load 104 (e.g., electric motor). An interface 106 may be used to deliver power from power source 102 to load 104.

Interface 106 may include one or more conductor structures. FIG. 1 shows example system 100 as including three conductor structures 108A, 108B, and 108C. Each of conductor structures 108A-108C may include one or more layers of a conductive material (e.g., a metal). Each of conductor structures 108A-108C may also include one or more layers of another conductive material (e.g., another metal). Each of conductors 108A, 108B, 108C may be used to deliver, to load 104, current that is supplied from power source 102. In some embodiments, one or more of conductor structures 108A, 108B, 108C may be a bus bar. In some embodiments, all of conductor structures 108A, 108B, 108C may be bus bars.

A controller 101 may be coupled to one or more current sensors. FIG. 1 shows example system 100 as including three current sensor devices 110A, 110B, 110C, each of which may be configured to measure current flowing in a respective conductor structure (e.g., current sensor device 110A measuring current in conductor structure 108A, current sensor device 110B measuring current in conductor 108B, current sensor device 110C measuring current in conductor 108C). The current sensor device(s) may be used to measure the level of current being supplied from power source 102 to load 104 through a respective conductor structure. These measurements may be provided to controller 101, and controller 101 may send signals to adjust operation of power source 102 and/or load in response to the measurements. Controller 101 may be, for example, an electronic control unit (ECU) or other controller of an EV, for example.

As previously discussed, additional circuitry and/or components not shown in FIG. 1 may be used to invert power or convert power provided from power source 102 to load 104.

FIG. 1 shows system 100 as including three conductor structures 108A, 108B, 108C. The three conductor structures may be used to provide three-phase power to load 104. For example, each of conductor structures 108A, 108B, 108C may provide an AC power signal with a phase that is separated by approximately 120 degrees from the other two of the conductor structures. That is, conductor structure 108B may provide an AC power signal that is 120 degrees phase-shifted from the AC power signal of conductor structure 108A, and conductor structure 108C may provide an AC power signal that is 240 degrees phase-shifted from the AC power signal of conductor structure 108A and 120 degrees phase-shifted from the AC power signal of conductor structure 108B.

A person of ordinary skill in the art would recognize that such three-phase power delivery is common in powering electric motors. However, the disclosure is not so limited. Any number of conductor structures providing any combination of currents should be considered to be within the scope of the disclosure herein. For example, any number of conductor structures providing any number of different phases of power may be provided in a system. In some systems, multiple conductor structures may provide power with the same phase shift, while other conductor structures may provide power with a different phase shift. In some systems, all the conductor structures may provide power of the same phase. In some systems, some of the conductor structures may provide DC power, while other conductor structures may provide AC power.

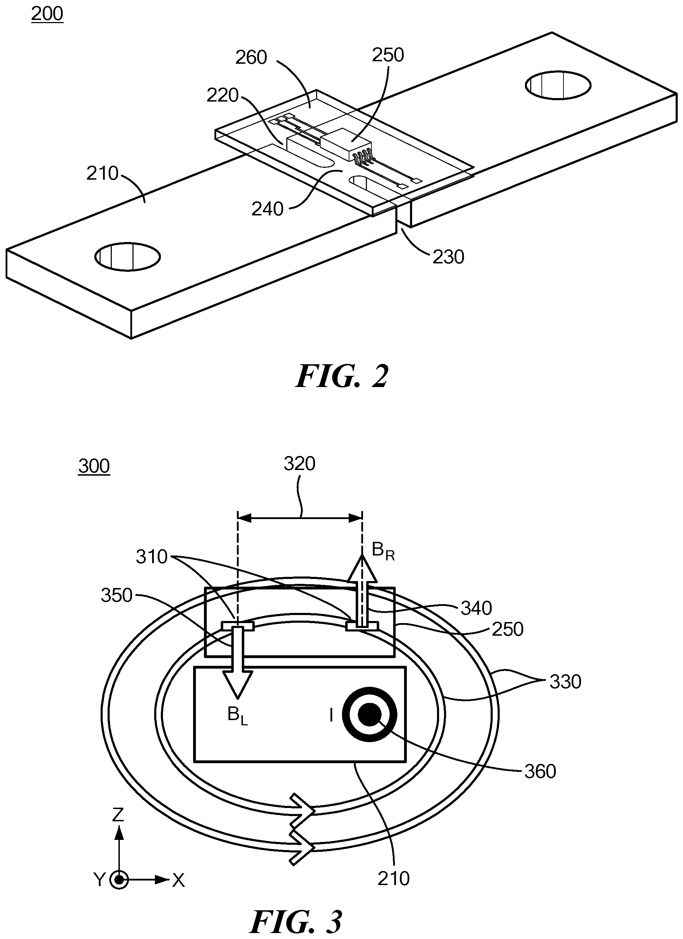

FIG. 2 is a diagram of an example system 200 for measuring current in a conductor structure 210. Conductor structure 210 may be, for example, the conductor structure of one or more of conductor structures 108A, 108B, 108C of FIG. 1. Conductor structure 210 may also be the conductor structure for each of conductor structures 108A, 108B, 108C of FIG. 1. Conductor structure 210 may be, for example, a bus bar. Conductor structure 210 may be capable of carrying a high current, such as currents ranging anywhere from 100 amperes (A) to greater than 4,000 A, though the disclosure is not so limited. A person of ordinary skill in the art would recognize that characteristics of a conductor structure may be varied to carry any level of current. Conductor structure 210 may be constructed in any of a variety of different shapes, such as flat strips, solid bars, and rods as just some examples. Conductor structure 210 may be composed of copper, brass, aluminum, or any other type of conductive material. Conductor structure 210 may alternatively be formed of a combination of different types of conductive materials, such as in layers. In some embodiments, conductor structure 210 may have connection points, shown in FIG. 2 as circular voids, to allow for coupling conductor structure 210 to another component or system, such as a power source (e.g., power source 102), a load (e.g., load 104), or another conductor structure.

A conductor structure may have one or more notches formed in it. For example, conductor structure 210 shown in FIG. 2 includes two notches, a notch 220 and a notch 230. Notch 220 and notch 230 may each be a void formed, for example, by cutting out (or stamping out) material used to form conductor structure 210. As such, notches 220 and 230 may extend all the way through the entire thickness of conductor structure 210. Forming notches 220 and 230 may cause conductor structure 210 to have a higher current density in a bridge portion 240 of the conductor between notches 220 and 230, thereby increasing the magnitude of the magnetic field in proximity to bridge portion 240. A current sensor device may then be placed in proximity to bridge portion 240 to measure an amount of current flowing through conductor structure 210. Placing the current sensor device in proximity to bridge portion 240 of conductor structure 210 where current density is higher may result in an improved signal-to-noise ratio (SNR) at the current sensor device, given the increased magnetic field strength near bridge portion 240. As a result, measurements of the current flowing through conductor structure 210 by the current sensor device may be improved by placing the current sensor device in proximity to bridge portion 240.

FIG. 2 shows an example system 200 where a current sensor device 250 is positioned above bridge portion 240 of conductor structure 210. For example, current sensor device 250 may be an integrated circuit (IC) mounted on a printed circuit board (PCB) 260 and positioned in proximity to bridge portion 240. Current sensor device 250 may be mounted on PCB 260 and placed in relation to conductor structure 210, such that current sensor device 250 is positioned directly above (or below) bridge portion 240, with some distance (e.g., air gap) separating current sensor device 250 from conductor structure 210. Current sensor device 250 may alternatively be placed off center (not directly above) bridge portion 240. Current sensor device 250 may be, for example, the Coreless, High Precision, Hall-effect Current Sensor IC (part number ACS37610) sold by Allegro MicroSystems, though the disclosure is not so limited. Current sensor device 250 may be implemented as an IC in a surface-mount thin-shrink small-outline (TSSOP) package, though the disclosure is not so limited. Although FIG. 2 shows current sensor device 250 mounted above bridge portion 240, current sensor device 250 may alternatively be mounted below bridge portion 240. Current sensor device 250 may be mounted such that PCB 260 is between current sensor device 250 and bridge portion 240, as shown in FIG. 2. Alternatively, current sensor device 250 may be mounted such that current sensor device 250 is between bridge portion 240 and PCB 260.

FIG. 3 is a diagram of an example system 300 for measuring current in a conductor. System 300 may be the same as system 200, but shown from a different perspective (i.e., looking at an end of conductor structure 210). As shown in FIG. 3, current (I) 360 may flow through conductor structure 210. In the example shown in FIG. 3, current 360 is flowing toward the viewer (i.e., in a direction parallel to the Y-axis). With current flowing in this direction, a cylindrical magnetic field will be induced around conductor structure 210. The direction of the magnetic field is shown by magnetic field lines 330. For example, using the right-hand rule, it may be determined that the magnetic field curls counterclockwise around conductor structure 210 from the viewer's perspective (i.e., in the plane formed by the X and Z axes) when current flows in a direction toward the viewer (in the Y-axis direction).

System 300 may include a current sensor device 250. Current sensor device 250 may be the same current sensor device as shown in system 200 of FIG. 2. Current sensor device 250 may include one or more magnetic field sensing elements. In the example shown in FIG. 3, current sensor device 250 includes two magnetic field sensing elements 310. The magnetic field sensing elements 310 may be placed apart from each other by a distance 320. Distance 320 may be, for example, between 2 and 3 millimeters (mm) (e.g., 2.58 mm), though the disclosure is not so limited. Magnetic field sensing elements 310 may be Hall effect elements, such as planar Hall elements, though the disclosure is not so limited.

When current flows through conductor structure 210, current sensor device 250 may measure a strength of a magnetic field induced by the current at each of its magnetic field sensing elements (e.g., magnetic field strength $B_R$ 340 at one of the magnetic field sensing elements and magnetic field strength $B_L$ 350 at the other of the magnetic field sensing elements). In the example of FIG. 3, the planar Hall elements of current sensor device 250 are positioned so as to be maximally sensitive to the magnetic field along the Z-axis, and thus may primarily measure the magnetic field strength along the Z-axis. A difference between the measured magnetic field strengths may then be determined and output as a differential sensed field strength (e.g., $B_{diff}$), which is proportional to the current flowing through conductor structure 210. For example, the relationship between the current applied to conductor structure 210 and the generated differential field may be described as:

$$\text{Equation 1:} \; B_{diff} = CF \times I$$

where $B_{diff}$ is the generated differential field strength induced between the two magnetic field sensing elements, $CF$ is a differential coupling factor (G (Gauss) /A (Amperes)), and I is the current flowing through conductor structure 210 (in amperes). The differential coupling factor ($CF$) may correspond to how well the amount of current flowing in the conductor is reflected in the differential magnetic field signal sensed by the current sensor.

Use of two differentially-coupled magnetic field sensing elements in a current sensor device (e.g., current sensor device 250) may allow the current sensor device to be immune to magnetic stray fields. For example, any magnetic field strength attributable to the environment, and not to a current flowing through a conductor structure 210, may be sensed by each of the two magnetic field sensing elements. Because a magnetic field strength attributable to the environment will be approximately equally sensed at the two magnetic field sensing elements (given their close proximity), any magnetic field strength measured by the magnetic field sensing elements that is attributable to the environment will largely cancel out when a difference is taken between the measurements of the two magnetic field sensing elements. That is, common-mode magnetic fields (i.e., common magnetic field strengths sensed by both magnetic field sensing elements) may be cancelled out through use of two differentially-coupled magnetic field sensing elements.

A system, such as system 200 of FIG. 2 and system 300 of FIG. 3, may allow a current sensor device (e.g., current sensor device 250) to measure high currents (e.g., 100 A to greater than 4,000 A) with high accuracy (e.g., accuracy within 1%). As a result, for certain applications a system such as system 200 or system 300 may be used instead of prior systems that may have utilized a magnetic shield or concentrator core to improve the accuracy of a current sensor in the system. This may be desirable, as magnetic shields and concentrator cores may be large and expensive components.

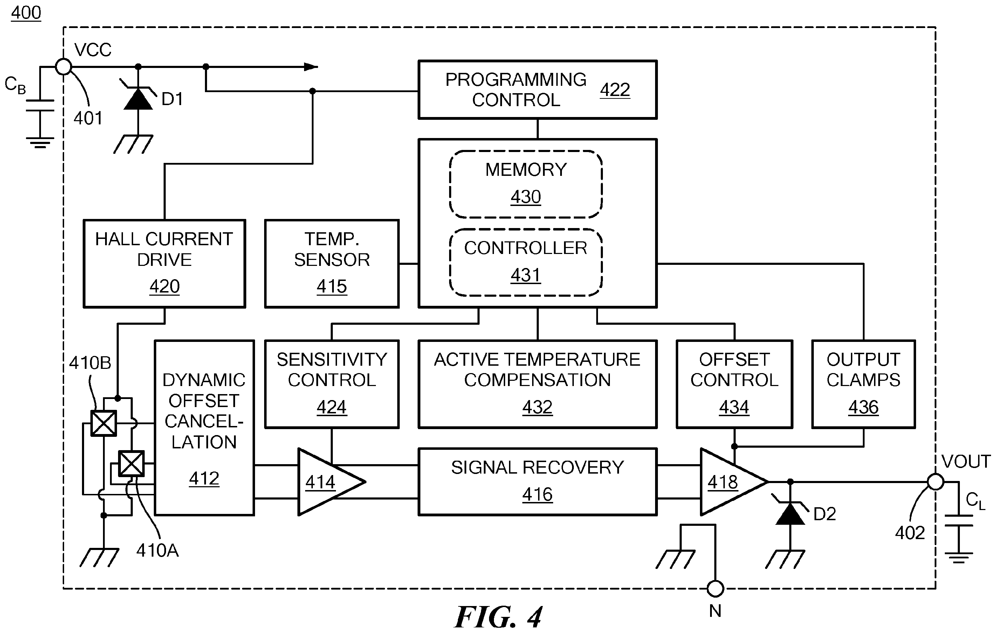

FIG. 4 is a diagram of an example current sensor device 400. In some embodiments, current sensor device 400 may be the same as current sensor device 250.

Current sensor device 400 may be configured to output a signal (e.g., VOUT) at a pin 402. For example, the output signal may be proportional to $B_{diff}$, where as previously discussed $B_{diff} = B_R$ (the magnetic field strength measured by one of the magnetic field sensing elements) - $B_L$ (the magnetic field strength measured by the other of the magnetic field sensing elements). Although these values are represented as a magnetic field strength (B), one of skill in the art would recognize that the magnetic field sensing elements may in practice output a signal that is proportional to magnetic field strength, such as a voltage that is representative of the magnetic field strength incident on a magnetic field sensing element. For example, each of the magnetic field sensing elements may output a voltage representative of a sensed magnetic field strength, and the differential signal may be the difference between these voltages.

The output signal (e.g., VOUT) may be proportional to the differential signal. For example, a sensor output VOUT may be described as

$$\text{Equation 2: } VOUT = \alpha \times B_{diff}$$

where VOUT is an output voltage, $B_{diff}$ is the differential signal (in volts) and $\alpha$ is a constant that corresponds to a sensitivity of the signal path in the current sensor device between $B_{diff}$ and VOUT.

Current sensor device 400 may include a voltage supply pin (e.g., VCC) 401 and an output signal (e.g., VOUT) pin 402. Voltage supply pin 401 may be used for an input power supply or supply voltage for current sensor device 400. A bypass capacitor (e.g., $C_B$) may be coupled between voltage supply pin 401 and a ground reference potential. In some embodiments, voltage supply pin 402 may also be used for programming current sensor device 400. Output signal pin 402 may be used for providing an output signal (e.g., VOUT) to circuits and systems (not shown), such as controller 101 of system 100 of FIG. 1. In some embodiments, output signal pin 402 may be used for programming current sensor device 400. An output load capacitance (e.g., $C_L$) may be coupled between output signal pin 402 and a ground reference potential. The example current sensor device in FIG. 4 includes a first diode D1 coupled between voltage supply pin 401 and a chassis ground, and a second diode D2 coupled between output signal pin 402 and the chassis ground. The example current sensor device in FIG. 4 also includes a pin N coupled to the chassis ground.

Current sensor device 400 may also include drive circuitry for driving one or more magnetic field sensing elements. For example, the current sensor device shown in FIG. 4 includes current drive circuitry 420 for driving Hall effect magnetic field sensing elements 410A and 410B.

Although shown in FIG. 4 as being Hall effect magnetic field sensing elements, the magnetic field sensing elements of a current sensor device (e.g., current sensor device 400) may include any number of different types of magnetic field sensing elements. The term "magnetic field sensing element" may be used herein to describe any of a variety of electronic elements that may be used to sense a magnetic field. A magnetic field sensing element may be any type of element sensitive to a magnetic field. For example, a magnetic field sensing element may be a Hall-effect element (e.g., a Hall plate), a magnetoresistance element, or a magnetotransistor element. For example, a magnetic field sensing element may be a Hall-effect element such as a planar Hall element (e.g., plate), a vertical Hall element (e.g., plate), or a circular vertical Hall (CVH) element (e.g., plate). A magnetic field sensing element may instead be a magnetoresistance element, such as an Indium Antimonide (InSb) element, a giant magnetoresistance (GMR) element (e.g., a spin valve element), an anisotropic magnetoresistance (AMR) element, a tunneling magnetoresistance (TMR) element, or a magnetic tunnel junction (MTJ) element. A magnetic field sensing element may be a receiving coil field sensing element. A magnetic field sensing element may be a single element, or alternatively may include two or more magnetic field sensing elements arranged in one of various configurations, such as a half bridge or a full (Wheatstone) bridge. Depending on the type of sensor device and application requirements, a magnetic field sensing element may be a device made of a type IV semiconductor material such as Silicon (Si) or Germanium (Ge), or of a type III-V semiconductor material such as Gallium-Arsenide (GaAs), or an Indium compound such as Indium-Antimonide (InSb).

Some of the above-described magnetic field sensing elements tend to have an axis of maximum sensitivity that is parallel to a substrate that supports the magnetic field sensing element, while others of the above-described magnetic field sensing elements tend to have an axis of maximum sensitivity that is perpendicular to a substrate that supports the magnetic field sensing element. For example, a planar Hall plate element may have an axis of maximum sensitivity that is perpendicular to a substrate, while a metal-based or metallic magnetoresistance element (e.g., GMR, TMR, AMR) or vertical Hall plate element may have an axis of maximum sensitivity that is parallel to a substrate.

Multiple magnetic field sensing elements in a current sensor device may be of the same type of magnetic field sensing element. For example, current sensor device 400 may include two magnetic field sensing elements 410A and 410B, which may be of the same type. Alternatively, a current sensor device may include different types of magnetic field sensing elements that work together. For example, current sensor device 400 may include two magnetic field sensing elements 410A and 410B, which may be of different types.

Moreover, while current sensor device 400 is shown as including two magnetic field sensing elements, the disclosure is not so limited. A current sensor device (e.g., current sensor device 400) may include any number of one or more magnetic field sensing elements.

Signals (e.g., voltages) output from magnetic field sensing elements 410A and 410B may be coupled to a dynamic offset cancellation circuit 412, which may cancel any voltage offset between the two magnetic field sensing elements (e.g., normalize the voltages output from the two magnetic field sensing elements). Dynamic offset cancellation circuit 412 may take various forms, such as chopping circuitry, and may function in conjunction with an offset control circuit 434 to remove any offset associated with the magnetic field sensing elements and/or amplifier 414. For example, dynamic offset cancellation circuit 412 may include one or more switches configurable to drive the magnetic field sensing elements (e.g., magnetic field sensing elements 410A and 410B) in two or more different directions, such that selected drive and signal contact pairs are interchanged during each phase of a chopping clock signal and such that offset voltages of the different driving arrangements tend to cancel.

Outputs from dynamic offset cancellation circuit 412 may be further coupled to an amplifier 414. Amplifier 414 may amplify the signals received at its inputs, and may output these amplified signals to a signal recovery circuit 416.

A programming control circuit 422 may be coupled between voltage supply pin 401 and a memory 430 and/or controller 431, to provide appropriate programming and control to memory 430 and/or controller 431. Memory 430 may include any suitable type of volatile and/or non-volatile memory. In some embodiments, the memory may be a non-transitory computer-readable medium. By way of example, memory 430 may include a random-access memory (RAM), a dynamic random-access memory (DRAM), an electrically-erasable programmable read-only memory (EEPROM), and/or any other suitable type of memory. Memory 430 may store instructions that, when executed by a controller (e.g., controller 431), cause the controller to carry out certain determinations, steps, processes, and/or calculations.

Controller 431 may include digital and/or analog circuitry. In some embodiments, controller 431 may be a digital controller. Controller 431 may include any suitable type of processing circuitry, such as an application-specific integrated circuit (ASIC), a field programmable gate array (FPGA), a coordinate rotation digital computer (CORDIC) processor, a special-purpose processor, synchronous digital logic, asynchronous digital logic, a general-purpose processor (e.g., microprocessor without interlocked pipelined stages (MIPS) processor, x86 processor), etc. The controller may also include a clock. The clock may, for example, timestamp when voltages (e.g., differential voltages) from magnetic field sensing elements are recorded (e.g., timestamp with an elapsed amount of time measured by the clock), such that determined current measurements and the times at which the current was measured may be stored in memory (e.g., memory 430). One of skill in the art would recognize that the clock need not be internal to the controller, and may instead be an external component connected to the controller.

A sensitivity control circuit 424 may be coupled to amplifier 414 to generate and provide a sensitivity control signal to amplifier 414 to adjust a sensitivity and/or operating voltage of amplifier 414. An active temperature compensation circuit 432 may be coupled to sensitivity control circuit 424, memory 430, controller 431, and/or offset control circuit 434, and may send signals to these components based on a temperature sensed by active temperature compensation circuit 432, such that these components adjust to compensate for a current temperature. For example, active temperature compensation circuit 432 may acquire temperature data from memory 430 and/or controller 431 and may perform necessary calculations or determinations to compensate for changes in temperature (e.g., as detected by temperature sensor 415), if needed.

Offset control circuit 434 may generate and provide an offset signal to a push/pull driver circuit 418 (which may be an amplifier) to adjust a sensitivity and/or operating voltage of driver circuit 418. Output clamps circuit 436 may be coupled between memory 430 and/or controller 431 and driver circuit 418 to limit output voltage when desired (e.g., during fault or error conditions) and/or for diagnostic purposes.

Although not shown, current sensor device 400 may include one or more voltage regulators. A voltage regulator may, for example, convert and/or regulate voltage to provide a stable power supply to the components of current sensor device 400.

Although current sensor device 400 has been described above as outputting a voltage signal (e.g.,

VOUT) at output pin 402, the disclosure is not so limited. A current sensor device may include any number of different types of output interfaces that are suitable for outputting a signal. An output interface may include one or more of a wired or wireless interface. By way of example, an output interface may include a voltage modulator for sending information along a conductor via voltage pulses, a current modulator for sending information along a conductor via current pulses, an Inter-Integrated Circuit ($I^2C$) interface, a Controller Area Network (CAN) bus interface, a WiFi interface, an Ethernet interface, a Universal Serial Bus (USB) interface, a local area network (LAN) interface, a cellular (e.g., 5G) interface, and/or any other suitable type of interface.

Although FIG. 4 and the discussion above provide certain examples of components and combinations of components that may be used in a current sensor device, the disclosure is not so limited. A current sensor device may use less components than described above, more components than described above, and/or different components than described above.

As discussed above, a system (e.g., system 200 of FIG. 2) that includes a current sensor device (e.g., current sensor device 250) and conductor structure (e.g., conductor structure 210) may allow for accurate current measurements (e.g., within 1% accuracy) to be taken when high currents are flowing through conductor structure 210. However, the accuracy of the current measurements of the current sensor device in such a system may be sensitive to misplacement of the current sensor device (e.g., current sensor device 250) relative to the conductor structure (e.g., conductor structure 210). For example, the air gap between the sensor device and the conductor structure may impact the accuracy of the current sensor device's measurements. Moreover, even if placement of the current sensor device in relation to the conductor structure is carefully calibrated, the relative positioning (e.g., air gap) between the current sensor device and the conductor structure may vary due to vibrations in the system, thermal expansion/contraction depending on temperature, or other factors.

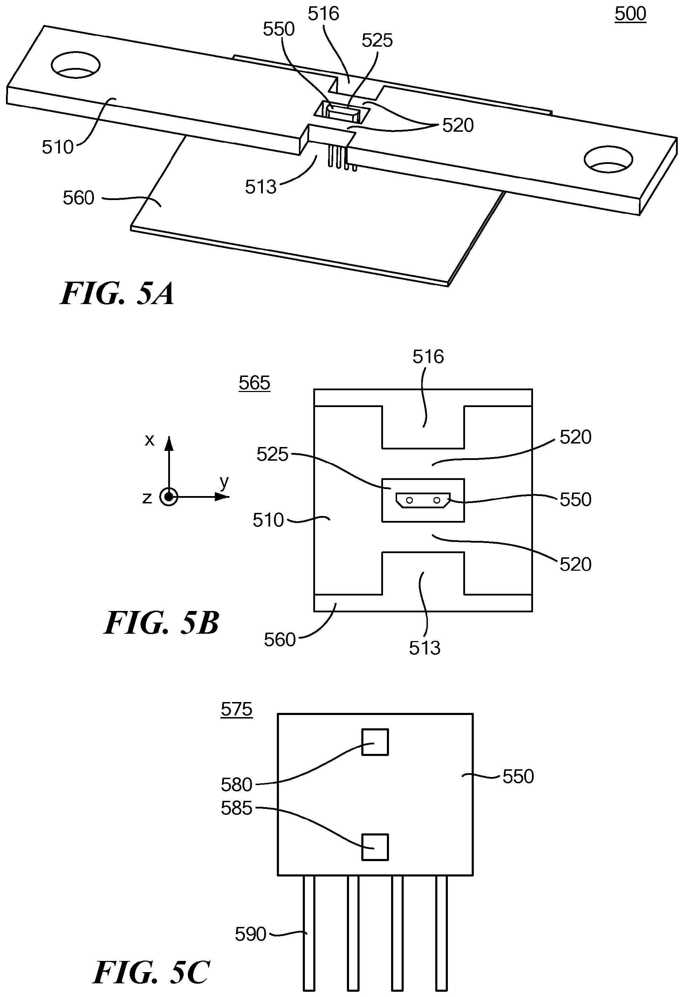

FIG. 5A is a diagram of another example system 500 for measuring a current in a conductor structure. Example system 500 may include a conductor structure 510, a current sensor device 550, and a PCB 560 on which current sensor device 550 is mounted.

Conductor structure 510 may be, for example, one or more of conductor structures 108A, 108B, 108C of FIG. 1. Conductor structure 510 may be, for example, a bus bar. Like conductor structure 210, conductor structure 510 may be capable of carrying a high current, such as currents ranging anywhere from 100 A to greater than 4,000 A, though the disclosure is not so limited. Conductor structure 510 may be constructed in a variety of different shapes, such as flat strips, solid bars, and rods as just some examples. Conductor structure 510 may be composed of copper, brass, aluminum, or any other type of conductive material. Conductor structure 510 may alternatively be formed of a combination of different types of conductive materials, such as in layers. Conductor structure 510 may have connection points, shown in FIG. 5A as circular voids, at its ends to allow for coupling conductor structure 510 to another component or system, such as a power source (e.g., power source 102), a load (e.g., load 104), or another conductor structure.

Conductor structure 510 shown in FIG. 5A includes two notches formed in it, notch 513 and notch 516. The notches of conductor structure 510 may be wider along a length of the conductor, and less deep along a width of the conductor, than the notches of conductor structure 210. Notches 513 and 516 may extend through a thickness of conductor structure 510, as shown in FIG. 5A. A hole 525 (or slit) is also formed in conductor structure 510. Hole 525 may extend through the thickness of conductor structure 510. Hole 525, notches 513, 516, and/or the holes at the ends of conductor structure 510 may be formed by cutting or stamping out material used to form conductive structure 510.

As shown in FIG. 5A, conductor structure 510 includes two conductive bridges 520 adjacent the notches and hole of the conductor structure. Conductive bridges 520 may allow current to pass along conductor structure 510. As discussed above with respect to conductor structure 210, bridges 520, being narrower in width than the overall conductive structure, may have a higher current density than in the rest of conductor structure 510, allowing a current sensor device (e.g., current sensor device 550) placed in proximity to bridges 520 to measure current with greater accuracy.

As shown in FIG. 5A, a current sensor device (e.g., current sensor device 550) may be positioned inside hole 525 of conductor structure 510. By positioning a current sensor device inside a hole of the conductor structure, the accuracy of the current sensor device's current measurements may be less sensitive to misplacements of the current sensor device relative to the conductor structure than in system 200 of FIG. 2.

A current sensor device in a TSSOP package, such as sensor device 250 as shown in FIG. 2, may be positioned in a hole of a conductor structure. However, positioning a current sensor device in a TSSOP package in a hole of a conductor structure may be challenging, given that the TSSOP package may need to be mounted on a PCB. A current sensor device may instead by implemented in a single in-line package (SIP), such as sensor device 550 of FIG. 5A. Other than the different packaging, current sensor device 550 may be designed similarly to current sensor device 250. For example, current sensor device 550 may be implemented as current sensor device 400 of FIG. 4. As shown in FIG. 5A, when implemented in a SIP package, a PCB 560 to which current sensor device 550 is connected may be positioned outside conductor structure 510, such that only current sensor device 550 is positioned in hole 525. Although shown as being positioned below conductor structure 510, PCB 560 may be positioned above conductor structure 510, or anywhere in proximity to conductor structure 510 such that current sensor device 550 may be connected to PCB 560. In some systems, a PCB 560 may not even be required, and current sensor device 550 may be coupled directed to one or more external components (e.g., controller 101) via one or more wires.

FIG. 5B is a diagram 565 of another view of the example system for measuring current in a conductor of FIG. 5A. For example, FIG. 5B shows a portion of system 500 of FIG. 5A, viewed from above. As shown in FIG. 5B, current sensor device 550 is positioned in hole 525 of conductor structure 510, and is connected to a PCB 560. Hole 550 and notches 513, 516 form two bridges 520, over which current may flow through conductor structure 510.

FIG. 5C is a diagram 575 of an example current sensor device 550 for measuring current in a conductor. As shown in FIG. 5C, current sensor device 550 may include a SIP package 550, in which the various components (see, e.g., current sensor device 400 of FIG. 4) of the current sensor device may be housed. Current sensor device 550 may also include one or more pins 590 for supplying power to current sensor device 550 and/or for providing signals to/from current sensor device 550. As previously discussed, a current sensor device may include one or more magnetic field sensing elements. FIG. 5C shows an example current sensor device 550 including two magnetic field sensing elements 580, 585, which may be planar Hall effect elements. As shown in FIG. 5C, the magnetic field sensing elements may be positioned apart from one another by some distance, such as in a range between 2-3 mm apart (e.g., 2.58 mm apart), though the disclosure is not so limited. In some embodiments, the magnetic field sensing elements may be substantially vertically aligned, as shown in FIG. 5C, though the disclosure is not so limited. Current sensor device 550 may be positioned in hole 525 of conductor structure 510, such that magnetic field sensing elements 580, 585 are maximally sensitive to a magnetic field along an X-axis direction (see FIG. 5B). For example, if magnetic field sensing elements 580, 585 are planar Hall effect elements, then when current sensor device 550 is positioned in hole 525, the sensitive plane of the planar Hall effect elements may face towards bridges 520.

As previously discussed with respect to FIG. 1, it may be desirable to place multiple conductor structures in proximity to each other. For example, the conductor structures may be utilized in a system that provides AC currents having different phases (e.g., a three-phase power system). In a three-phase power system, for example, three conductor structures may be utilized, where a second conductor structure provides current that is phase-shifted by 120 degrees from a first conductor structure, and where a third conductor structure provides current that is phase-shifted by 240 degrees from the first conductor structure, and by 120 degrees from the second conductor structure.

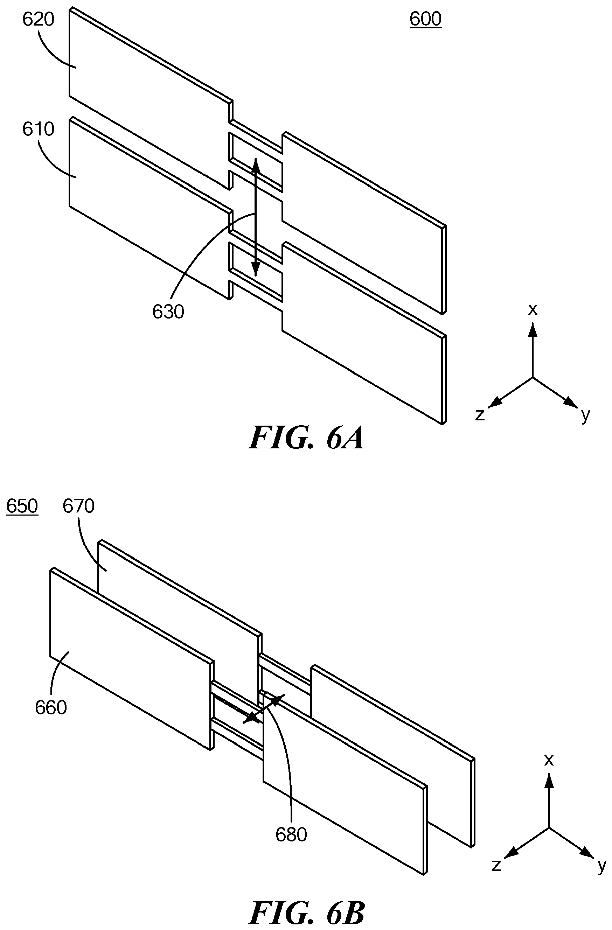

FIG. 6A is a diagram 600 showing an example arrangement of two example conductor structures in a system. Each of conductor structures 610 and 620 may be the same as conductor structure 510. As shown in FIG. 6A, conductor structures 610 and 620 may be positioned such that they are in proximity and adjacent to one another along a plane defined by an X-axis and a Y-axis. That is, conductor structures 610 and 620 may be placed in relation to each other such that a top flat surface of conductor structure 610 is substantially parallel to a top flat surface of conductor structure 620 in an X-Y plane, such that a bottom flat surface of conductor structure 610 is substantially parallel to a bottom flat surface of conductor structure 620 in an X-Y plane, and such that ends of the conductor structures are substantially aligned. Conductor structure 610 and conductor structure 620 may be positioned such that the centers of the holes of the conductor structures are positioned a distance 630 (e.g., a center-to-center distance) from each other. Although only two conductor structures are shown in FIG. 6A, one of skill in the art would recognize that any number of conductor structures may be positioned adjacent to each other in a plane as shown in FIG. 6A. For example, in a three-phase power system utilizing three conductor structures, a third conductor structure may be positioned along the plane defined by the X-axis and the Y-axis, such that a center of a hole of the third conductor structure is positioned a distance 630 from a hole of either conductor structure 610 or conductor structure 620. The arrangement shown in FIG. 6A may be referred to as a "standard vertical slit" arrangement herein.

FIG. 6B is diagram 650 showing another example arrangement of two example conductor structures in a system. Each of conductor structures 660 and 670 may be the same as conductor structure 510. As shown in FIG. 6B, conductor structures 660 and 670 may be positioned such that they are in proximity and adjacent to one another along a plane defined by an X-axis and a Z-axis. That is, conductor structures 660 and 670 may be placed in relation to each other such that a bottom flat surface of conductor structure 660 faces a top flat surface of conductor structure 670, and such that ends of the conductor structures are substantially aligned. Conductor structure 660 and conductor structure 670 may be positioned such that the centers of the holes of the conductor structures are positioned a distance 660 from each other. Although only two conductor structures are shown in FIG. 6B, one of skill in the art would recognize that any number of conductor structures may be positioned adjacent to each other in a plane as shown in FIG. 6B. For example, in a three-phase power system utilizing three conductor structures, a third conductor structure may be positioned along the plane defined by the X-axis and the Z-axis, such that a center of a hole of the third conductor structure is positioned a distance 680 from a hole of either conductor structure 660 or conductor structure 670. The arrangement shown in FIG. 6B may be referred to as a "stacked vertical slit" arrangement herein.

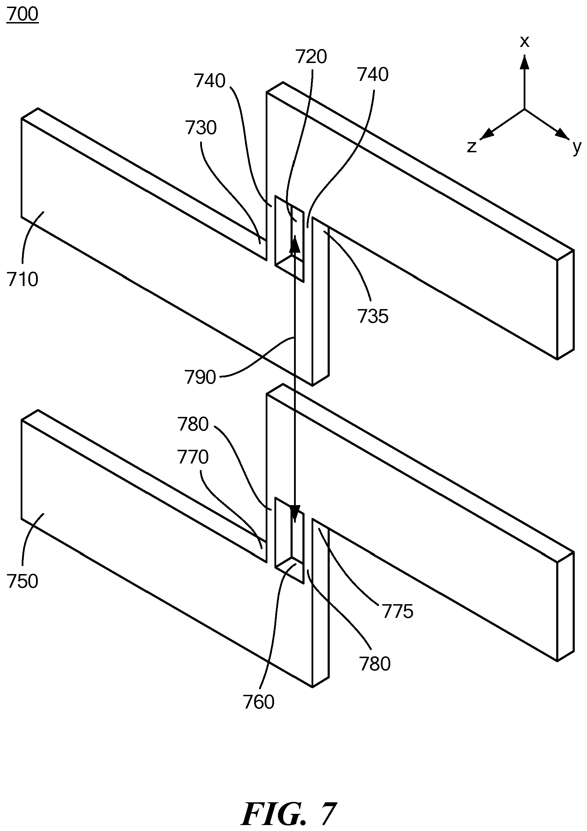

FIG. 7 is a diagram 700 showing still another arrangement of two example conductor structures in a system. For example, FIG. 7 shows example conductor structure 710 and example conductor structure 750. Conductor structure 710 and conductor structure 750 may have the same composition and the same configuration. Each of conductor structure 710 and 750 may be a bus bar. Each of conductor structure 710 and 750 may be capable of carrying a high current, such as currents ranging anywhere from 100 A to over 4,000 A, though the disclosure is not so limited. Each of conductor structure 710 and 750 may be constructed in any of a variety of different shapes, such as flat strips, solid bars, and rods as just some examples. Each of conductor structure 710 and 750 may be composed of copper, brass, aluminum, or any other type of conductive material. Each of conductor structures 710 and 750 may alternatively be formed of a combination of different types of conductive materials, such as in layers. Although not shown in FIG. 7, each of conductor structures 710 and 750 may have connection points, such as circular voids, for connecting the conductor structure to another component or system, such as a power source (e.g., power source 102), a load (e.g., load 104), or another conductive structure.

Like conductor structure 510, conductor structures 710 and 750 each include a hole in which a current sensor device may be positioned, as shown in FIG. 7. For example, conductor structure 710 includes a hole 720, and conductor structure 750 includes a hole 760. Unlike conductor structures 210 and 510, conductor structures 710 and 750 do not include notches. Rather, each of conductor structures 710 and 750 includes elbows where the conductor turns 90 degrees. For example, conductor structure 710 includes an elbow 730 at which the conductor structure turns 90 degrees, and another elbow 735 at which the conductor structure turns 90 degrees. Similarly, conductor structure 750 includes an elbow 770 at which the conductor structure turns 90 degrees, and another elbow 775 at which the conductor structure turns 90 degrees. The elbows cause the conductor structures to have two bridges positioned proximate to the hole where the current sensor device will be placed, allowing the current sensor device to make accurate current measurements. For example, conductor structure 710 may include bridges 720, and conductor structure 750 may include bridges 780.

As shown in FIG. 7, conductor structures 710 and 750 may be placed in proximity and adjacent to one another along a plane defined by an X-axis and a Y-axis. That is, conductor structures 710 and 750 may be placed in relation to each other such that a top flat surface of conductor structure 710 is parallel to a top flat surface of conductor structure 750 in an X-Y plane, such that a bottom flat surface of conductor structure 710 is parallel to a bottom flat surface of conductor structure 750 in an X-Y plane, and such that ends of the conductor structures are substantially aligned. Conductor structure 710 and conductor structure 750 may be positioned such that the centers of the holes of the conductor structures are positioned a distance 790 from each other. Although only two conductor structures are shown in FIG. 7, one of skill in the art would recognize that any number of conductor structures may be positioned adjacent to each other in a plane as shown in FIG. 7. For example, in a three-phase power system utilizing three conductor structures, a third conductor structure may be positioned along the plane defined by the X-axis and the Y-axis, such that a center of a hole of the third conductor structure is positioned a distance 790 from a hole of either conductor structure 710 or conductor structure 750. The arrangement shown in FIG. 7 may be referred to as a "90° vertical slit" arrangement herein.

Although not shown in FIGs. 6A, 6B, or 7, a current sensor device (e.g., current sensor device 550) may be placed in the hole of each respective conductor structure, such that current flowing through each of the conductor structures may be measured by its respective current sensor device. These measurements may then be transmitted to another component or system, such as controller 101 of FIG. 1, which may take actions based on the current measurements.

A possible advantage of using conductor structure(s) 510 in an arrangement as shown in FIG. 6A or 6B, and as discussed above, is that the conductor structures may be packed relatively closely together. Moreover, as discussed above, placement of current sensor devices in the holes of the conductor structures may mitigate misplacement error in current sensor device measurements.

One potential downside of using conductor structure(s) 510 in an arrangement as shown in FIG. 6A is that, as previously discussed, magnetic field sensing elements in a current sensor device, when placed in a hole of a conductor structure, may be oriented to sense a magnetic field in a direction facing an adjacent conductor structure (e.g., may be oriented to be sensitive to the magnetic field along the X-axis direction of FIG. 6A). Thus, when a current sensor is positioned in a hole of a conductor structure and current is flowing in an adjacent conductor structure, the current sensor may sense the magnetic curl field associated with the current flowing in the adjacent conductor structure. As a result, the current sensor device may attribute this magnetic field strength as being associated with a current in the conductor in which it is positioned, when in fact the sensed magnetic field strength is attributable to a current flowing in the adjacent conductor structure. This error may be referred to as a "crosstalk error" herein. The crosstalk error may result in a current measurement by a current sensor device in such an arrangement to be off by an amount (e.g., 1.5%, 2%) that may depend on how closely the conductor structures are packed together.

Using conductor structure(s) 510 in the arrangement shown in FIG. 6B may not significantly improve crosstalk error of the system, because when the current sensor device is positioned in a hole of a conductor structure in the arrangement of FIG. 6B, it will still be sensitive to the magnetic curl field caused by any current flowing in an adjacent conductor structure.

Using conductor structures in the arrangement shown in FIG. 7 may improve crosstalk error of a system. As shown in FIG. 7, conductor structure 710 and conductor structure 750 are configured such that the hole (e.g., hole 720, hole 760) in which the current sensor device (e.g., current sensor device 550) is positioned is turned sidewise (i.e., rotated by 90 degrees from the examples of FIGs. 6A, 6B). As a result, the current sensor device (e.g., current sensor device 550) would be rotated 90 degrees from its orientation in the FIG. 6A and FIG. 6B examples, and would be placed in the hole (e.g., hole 720, hole 760) such that the magnetic field sensor elements (e.g., planar Hall effect elements) are maximally sensitive to the magnetic field along the Y-axis direction (e.g., the lengthwise direction of the conductor structure). As a result, a current sensor device positioned in a hole (e.g., hole 720) of a conductor structure (e.g., conductor structure 710) will not be very sensitive to the magnetic curl field generated by current flowing through an adjacent structure (e.g., conductor structure 750).

One potential downside of using conductor structures (e.g., conductor structure 710, conductor structure 750) in an arrangement as shown in FIG. 7 is that it may no longer be possible to pack the conductor structures closely together. While it may be possible to nest the conductor structures (e.g., place a conductor structure within an elbow of a neighboring conductor structure), crosstalk error would then increase because the current sensor device would be sensitive to the magnetic curl field generated by a current flowing through the adjacent conductor structure. Thus, to keep crosstalk error low, the conductor structures would have to be vertically aligned as shown in FIG. 7, which would limit how closely the conductor structures could be packed together.

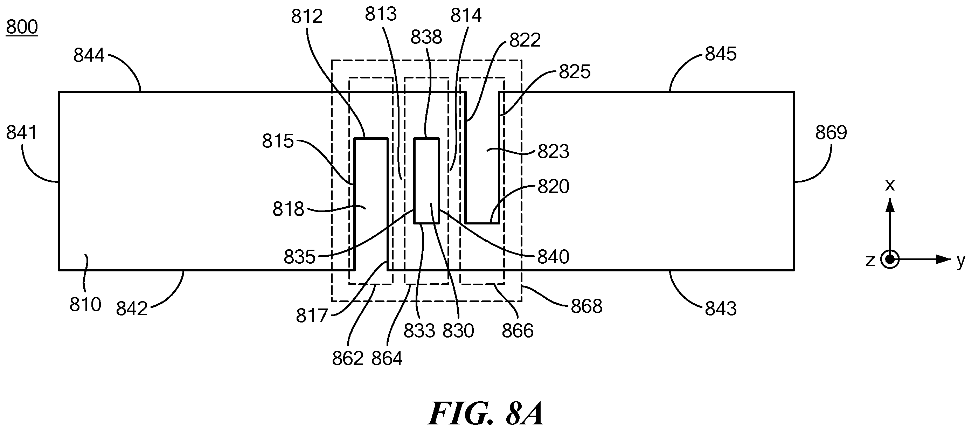

FIG. 8A is a diagram 800 of an example conductor structure 810, consistent with embodiments of the present disclosure. Example conductor structure 810 may be configured in such a way that it mitigates misplacement error of placing a current sensor device in relation to the conductor structure. Example conductor structure 810 may also be configured such that multiple conductor structures 810 may be placed in close proximity to each other. Example conductor structure 810 may further be configured such that crosstalk error in a system is reduced. That is, by using multiple conductor structures 810 placed in proximity with each other, a current sensor device placed in a hole of a first conductor structure may accurately measure an amount of current flowing through the first conductor structure, and may not be very sensitive to the magnetic curl field generated by currents flowing through adjacent conductor structures.

Conductor structure 810 may be a bus bar, and may be capable of carrying a high current, such as currents ranging anywhere from 100 A to over 4,000 A, though the disclosure is not so limited. Conductor structure 810 may be constructed in any of a variety of different shapes, such as flat strips, solid bars, and rods as just some examples. Conductor structure 810 may be composed of copper, brass, aluminum, or any other type of conductive material. Conductor structure 810 may alternatively be formed of a combination of different types of conductive materials, such as in layers. Although not shown in FIG. 8A, conductor structure 810 may include connection points, such as circular voids, for connecting the conductor structure to another components or system, such as a power source (e.g., power source 102), a load (e.g., load 104), or another conductive structure. A conductor structure 810 may be used, for example, for each of conductors 108A, 108B, 108C in system 100 of FIG. 1.

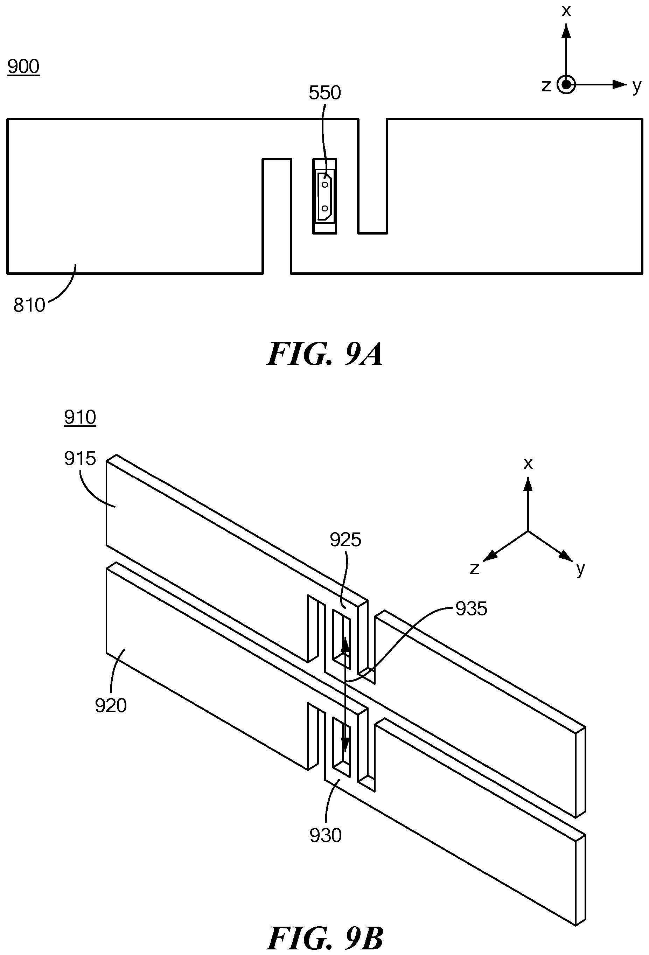

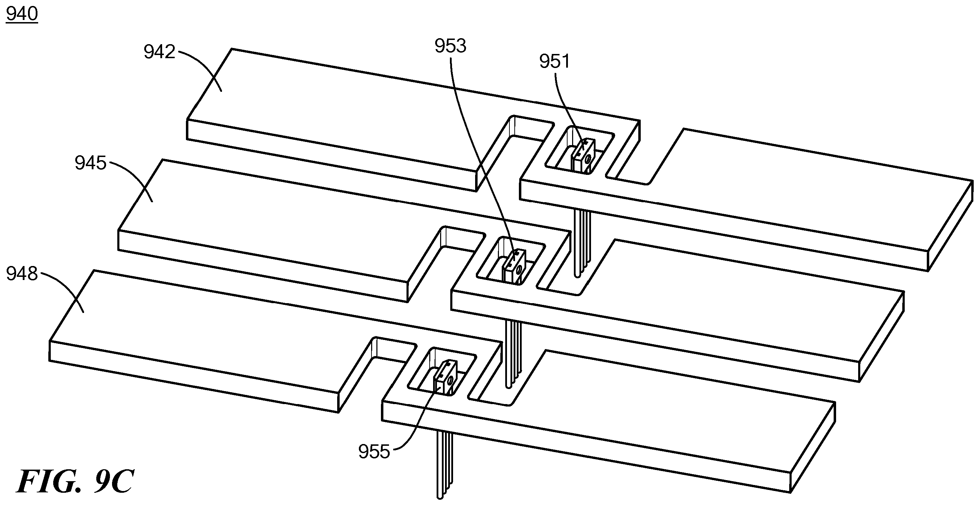

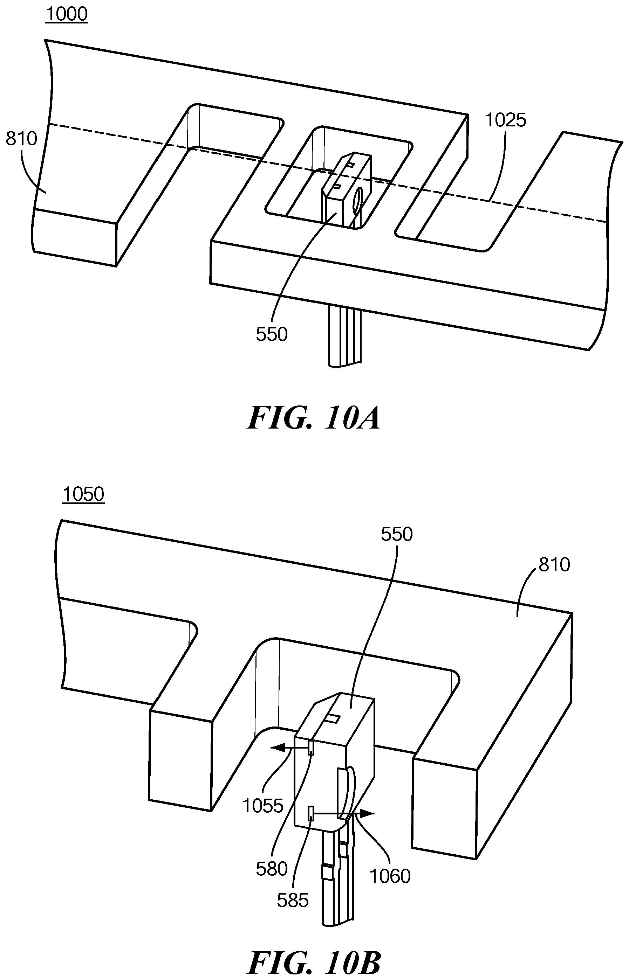

Like conductor structure 510 and conductor structures 710 and 750, conductor structure 810 may include a hole 830 in which a current sensor device may be positioned (as shown in FIGs. 9A, 9C, 10A, and 10B). Like the holes in conductor structures 510, 710, and 750, hole 830 may allow a current sensor device to be positioned inside the hole of the conductor structure, thereby reducing the sensitivity of the current sensor device to misplacements of the current sensor device relative to the conductor structure as compared to system 200 of FIG. 2. As previously discussed, although a current sensor device in a TSSOP package may be placed in a hole such as hole 830, it may be desirable to instead utilize a current sensor device in a SIP package for placement in a hole such as hole 830. The current sensor device (e.g., current sensor device 550) may be used, for example, for each of current sensor devices 110A, 110B, 110C in system 100 of FIG. 1.

Like the holes in conductor structures 710 and 750, hole 830 may be turned sidewise (i.e., rotated by 90 degrees) as compared to the hole of conductor structure 510 in FIGs. 6A and 6B. As a result, a current sensor device (e.g., current sensor device 550) may be rotated by 90 degrees from its orientation in the FIG. 6A and FIG. 6B examples, and may be placed in hole 830 such that the magnetic field sensing elements (e.g., planar Hall effect elements or Hall plates) of the current sensor device are maximally sensitive to the magnetic field along the Y-axis direction (e.g., the lengthwise direction of the conductor structure). As a result, a current sensor device positioned in hole 830 of conductor structure 810 may not be very sensitive to the magnetic curl field generated by current flowing through an adjacent conductor structure.

Conductor structure 810 may also include a notch 818 formed on one side of conductor structure 810, and a notch 823 formed on the other side of conductor structure 810. In some embodiments, notch 818 and notch 823 of conductor structure 810 may be formed such that they pass all the way through a thickness of conductor structure 810. As a result of notches 818 and 823 having been formed, two bridges 813 and 814 may remain, which may allow current to pass along conductor structure 810. As discussed above with respect to conductor structure 210, conductor structure 510, and conductor structures 710 and 750, bridges 813, 814, being narrower in width than the overall conductive structure, may have a higher current density than in the rest of conductor structure 810, allowing a current sensor device (e.g., current sensor device 550) placed in proximity to bridges 813, 814 to measure current with greater accuracy.

In some embodiments, hole 830 may be formed in a portion 864 of conductor structure 810, such that portion 864 defines the hole. In some embodiments, hole 830 may be formed so as to pass through a thickness of conductor structure 810, such as all the way through a thickness of conductor structure 810. Hole 830 may have a rectangular shape when viewed from above, though the disclosure is not so limited. For example, hole 830 may have any of a variety of different shapes. In the example shown in FIG. 8A, hole 830 has four edges, edge 835, edge 840, edge 833, and edge 838. In some embodiments, edges 835 and 840 may be parallel to each other. In some embodiments, edges 833 and 838 may be parallel to each other. In some embodiments, edges 838 and 833 may have the same length along one dimension (e.g., along a Y-axis direction). In some embodiments, edges 835 and 840 may have the same length along one dimension (e.g., along an X-axis direction). The term "dimension" may be used herein to refer to a direction that is along or parallel to an axis (e.g., Y-axis of FIG. 8A). That is, edges 835 and 840 of FIG. 8A may be considered to be along a first dimension (e.g., dimension along or parallel to an X-axis) and edges 833 and 838 of FIG. 8A may be considered to be along a second dimension (e.g., dimension along or parallel to a Y-axis). In some embodiments, edges 835 and 840 may be longer than edges 833 and 838, though the disclosure is not so limited.

In some embodiments, a notch 818 may be formed in a portion 862 of conductor structure 810, such that portion 862 defines the notch. In some embodiments, notch 818 may be formed so as to pass through a thickness of conductor structure 810, such as all the way through a thickness of conductor structure 810. In some embodiments, notch 818 may have a rectangular shape when viewed from above (with one side of the rectangle missing), though the disclosure is not so limited. For example, notch 818 may have any of a variety of different shapes. In the example shown in FIG. 8A, notch 818 has three edges, edge 815, edge 817, and edge 812. In some embodiments, edges 815 and 817 may be parallel to each other. In some embodiments, edges 815 and 817 may have the same length along one dimension (e.g., along an X-axis direction). In some embodiments, each of edges 815 and 817 may be longer than edge 812, though the disclosure is not so limited.

In some embodiments, a notch 823 may be formed in a portion 866 of conductor structure 810, such that portion 866 defines the notch. In some embodiments, notch 823 may be formed so as to pass through a thickness of conductor structure 810, such as all the way through a thickness of conductor structure 810. In some embodiments, notch 823 may have a rectangular shape when viewed from above (with one side of the rectangle missing), though the disclosure is not so limited. For example, notch 823 may have any of a variety of different shapes. In the example shown in FIG. 8A, notch 823 has three edges, edge 822, edge 825, and edge 820. In some embodiments, edges 822 and 825 may be parallel to each other. In some embodiments, edges 822 and 825 may have the same length along one dimension (e.g., along an X-axis direction). In some embodiments, each of edges 822 and 825 may be longer than edge 820, though the disclosure is not so limited.

As shown in FIG. 8A, notch 818 may be formed out of one side of conductor structure 810, while notch 823 may be formed out of the other side of conductor structure 810. As a result, one side of conductor structure 810 may include an edge 842, followed by a gap formed by notch 818, followed by another edge 843. The other side of conductor structure 810 may include an edge 844, followed by a gap formed by notch 823, followed by another edge 845. Conductor structure 810 may also include edges 841 and 869. As shown in FIG. 8A, edges 841 and 869 may be along one dimension (e.g., a direction along or parallel to an X-axis) and edges 842, 843, 844, and 845 may be along another dimension (e.g., a direction along or parallel to a Y-axis).

As further shown in FIG. 8A, portions 862, 864, and 866 including notches 818, 823 and hole 830 may together form a portion 868 of conductor structure 810. Portion 868 may have an overall shape that looks similar to the letter "S" and may be referred to as an "S-notch portion." Conductor structure 810 may be referred to as having an "S-notch vertical slit" arrangement herein.

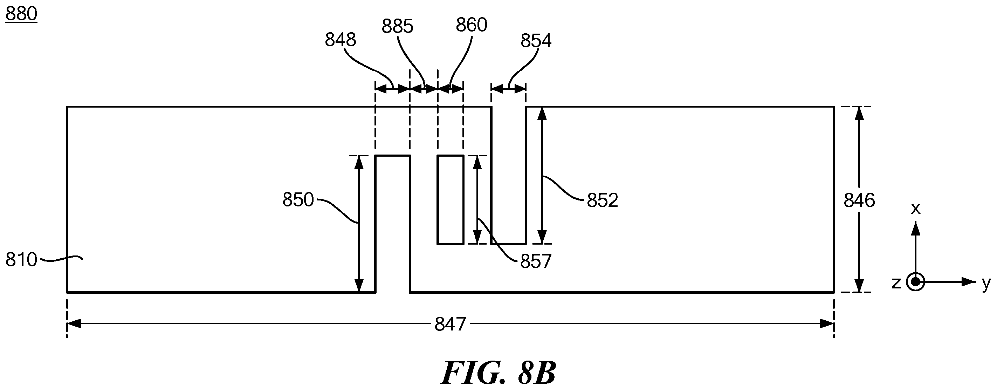

FIG. 8B is another diagram 880 of example conductor structure 810 of FIG. 8A, consistent with embodiments of the present disclosure. As shown in FIG. 8B, conductor structure 810 may have an overall width 846 along a first dimension (e.g., direction along or parallel to an X-axis) and an overall length 847 along a second dimension (e.g., direction along or parallel to a Y-axis). For example, width 846 may be a width in a range between 10-25 millimeters (mm), and length 847 may be a length in a range between 70-1,000 mm, though the disclosure is not so limited.

In some embodiments, edge 838 of hole 830 may have a length 860 in a range between 5-7 mm, and edge 840 of hole 830 may have a length 857 in a range between 8-12 mm, though the disclosure is not so limited. In some embodiments, edges 835 and 840 of conductor structure 810 may have the same length, though the disclosure is not so limited. In some embodiments, edges 838 and 833 of conductor structure 810 may have the same length, though the disclosure is not so limited.

In some embodiments, edge 815 of notch 818 may have a length 850 in a range between 15-30 mm, though the disclosure is not so limited. In some embodiments, edge 817 of notch 818 may also have a length in a range between 15-30 mm, though the disclosure is not so limited. In some embodiments, the lengths of edges 815 and 817 may be the same. In some embodiments, the lengths of edges 815 and 817 may be different. In some embodiments, edge 812 of notch 818 may have a length 848 in a range between 2 and 15 mm, though the disclosure is not so limited. In some embodiments, the length of edges 817 and/or 815 may be longer than the length of edge 812, though the disclosure is not so limited.

In some embodiments, edge 825 of conductor notch 823 may have a length 852 in a range between 15-30 mm, though the disclosure is not so limited. In some embodiments, edge 822 of conductor structure 810 may also have a length in a range between 15-30 mm, though the disclosure is not so limited. In some embodiments, the lengths of edges 825 and 822 may be the same. In some embodiments, the lengths of edges 822 and 825 may be different. In some embodiments, edge 820 may have a length 854 in a range between 2 and 15 mm, though the disclosure is not so limited. In some embodiments, the length of edges 825 and/or 822 may be longer than the length of edge 820, though the disclosure is not so limited.

In some embodiments, a bridge (e.g., bridge 813, 814) of conductor structure 810 may have a width 885 in a range between 1-5 mm, though the disclosure is not so limited. In some embodiments, bridges 813 and 814 may have the same width, while in other embodiments bridges 813 and 814 may have different widths. In some embodiments, a bridge (e.g., bridge 813, 814) of conductor structure 810 may have a length 857 in a range between 8-12 mm, though the disclosure is not so limited. In some embodiments, bridges 813 and 814 may have the same length, while in other embodiments bridges 813 and 814 may have different lengths.

Although not apparent from the two-dimensional view of FIG. 8B, conductor structure may also have a thickness (see, e.g., FIGs. 9B, 9C, 10A, 10B). The thickness may be in a range between 0.5-5 mm, though the disclosure is not so limited.

Although example dimensions of conductor structure 810 have been provided above, the disclosure is not limited to these dimensions. A person of ordinary skill in the art would recognize that a variety of different dimensions and configurations of a conductor structure may be used. Any dimensions and/or configurations of a conductor structure that perform substantially the same function in substantially the same way to achieve the same result should be considered to be within the scope of the disclosure herein. For example, one of skill in the art would recognize that dimensions and configurations of a conductor structure may be varied depending on the needs of a particular application and/or a desired result (e.g., improved crosstalk performance). Such variations should be considered to be within the scope of the disclosure herein.

FIG. 9A is a diagram of an example system 900 including example conductor structure 810 of FIGs. 8A and 8B and current sensor device 550, consistent with embodiments of the present disclosure. As shown in FIG. 9A, current sensor device 550 may be positioned in hole 830, such that magnetic field sensing elements of the current sensor are oriented to be maximally sensitive to a magnetic field along the lengthwise direction of conductor structure (e.g., in a direction along or parallel to a Y-axis). Thus, as will further be discussed below, current sensor device 550 may sense a current flowing through bridges 813, 814 without being very sensitive to a magnetic field generated by a current flowing in an adjacent conductor structure.

In some embodiments, one side of current sensor device 550 may be positioned in a range of 2-4 mm from edge 838 of conductor structure 810 and another side of current sensor device 550 may be positioned in a range of 2-4 mm from edge 833 of conductor structure. In some embodiments, a face (e.g., front or back) of current sensor device 550 may be positioned in a range of 1-2 mm from edge 840 of conductor structure 810, and the other face (e.g., front or back) of current sensor device 550 may be positioned in a range of 1-2 mm from edge 835 of conductor structure 810. However, the disclosure is not so limited. In some embodiments, current sensor device 550 may be ideally positioned with respect to conductor structure 810 when a midpoint between the magnetic field sensing elements (i.e., a location halfway between the magnetic field sensing elements) is centered within hole 830 (i.e., when the distances between the midpoint and the respective edges 833, 838 of conductor structure 810 are the same, when the distances between the midpoint and the respective edges 835, 840 of conductor structure 810 are the same, and when the distances between the midpoint and the upper surface and lower surface of conductor structure 810 are the same).

FIG. 9B is a diagram of an arrangement 910 of two example conductor structures 915 and 920 positioned in proximity to one another, consistent with embodiments of the present disclosure. For example, each of the conductor structures may be configured as conductor structure 810. Conductor structure 915 may include a portion 925 (e.g., S-notch portion with a hole and two notches) and conductor structure 920 may include a portion 930 (e.g., S-notch portion with a hole and two notches). The center of the holes of the two conductor structures may be positioned apart by a distance 935 (e.g., center-to-center distance).

As shown in FIG. 9B, conductor structures 915 and 920 may be placed in proximity and adjacent to one another along a plane defined by an X-axis and a Y-axis. That is, conductor structures 915 and 920 may be placed in relation to each other such that a top flat surface of conductor structure 915 is parallel to a top flat surface of conductor structure 920 in an X-Y plane, such that a bottom flat surface of conductor structure 915 is parallel to a bottom flat surface of conductor structure 920 in an X-Y plane, and such that ends of the conductor structures are substantially aligned. Conductor structure 915 and conductor structure 920 may be positioned such that the centers of the holes of the conductor structures are positioned a distance 935 (e.g., a center-to-center distance) from each other. Although only two conductor structures are shown in FIG. 9B, one of skill in the art would recognize that any number of conductor structures may be positioned adjacent to each other in a plane as shown in FIG. 9B. For example, in a three-phase power system utilizing three conductor structures, a third conductor structure (e.g., conductor structure 810) may be positioned along the plane defined by the X-axis and the Y-axis, such that a center of a hole of the third conductor structure is positioned a distance 935 from a hole of either conductor structure 915 or conductor structure 920. However, the disclosure is not so limited. For example, a distance 935 between the centers of the holes of two conductor structures may be smaller or greater than a distance between the center of a hole of a third conductor structure and the center of the hole of either of the other two conductor structures.

Arranging conductor structures configured as conductor structure 810 in an arrangement 910 may allow the conductor structures to be packed closely together. Moreover, the vertical slit of conductor structure 810 may minimize effects of misplacement of the current sensor device (e.g., current sensor device 550) with respective to conductor structure 810 on the current sensor device's accuracy. The current density of bridges 813, 814 of conductor structure 810 may also improve the accuracy of the current sensor device's measurements. Additionally, when the current sensor device (e.g., current sensor device 550) is placed within hole 830 of conductor structure 810, the magnetic field sensing elements of the current sensor device may be maximally sensitive to the magnetic field along a Y-axis direction, and may therefore have little sensitivity to the magnetic curl field generated by current flowing through an adjacent conductor structure.

FIG. 9C is a diagram of a system 940 including three example conductor structures 942, 945, 948 positioned in proximity to one another, and with three current sensor devices 951, 953, 955, each of the current sensor devices positioned to sense current in a respective conductor structure (e.g., current sensor device 951 positioned to sense current in conductor structure 942, current sensor device 953 positioned to sense current in conductor structure 945, current sensor device 955 positioned to sense current in conductor structure 948), consistent with embodiments of the present disclosure. For example, system 940 may be a system of conductor structures and current sensor devices for use in a three-phase power system. In some embodiments, conductor structures 942, 945, 948 may correspond to conductors 108A, 108B, 108C of FIG. 1, and current sensor devices 951, 953, 955 may correspond to current sensor devices 110A, 110B, 110C of FIG. 1. As previously discussed, current sensor devices 951, 953, 955 may be coupled via their pins to wires and/or PCBs, which may be further coupled to a controller (e.g., ECU), such as controller 101 of system 100 of FIG. 1. The controller may use the current measurements received from the current sensor devices to control a power source (e.g., 102) and/or load (e.g., 104).

FIG. 10A is a diagram of a close-up view 1000 of a portion (e.g., S-notch portion with positioned current sensor device) of the system of FIG. 9A. FIG. 10A shows an axis 1025 along which a cross section is taken, resulting in the view shown in FIG. 10B.

FIG. 10B is a diagram of close-up view 1050 of a current sensor device 550 positioned within the system of FIG. 9A, with a cross-section taken along axis 1025. As shown, current sensor device 550 may include magnetic field sensing elements configured to be maximally sensitive to a magnetic field along a Y-axis (see FIG. 9B). For example, FIG. 10B shows two magnetic field sensing elements 580, 585 (e.g., Hall plates) in current sensor device 550, with magnetic field sensing element 580 oriented to be maximally sensitive to a magnetic field 1055 along the Y-axis, and with magnetic field sensing element 585 oriented to be maximally sensitive to a magnetic field 1060 along the Y-axis.

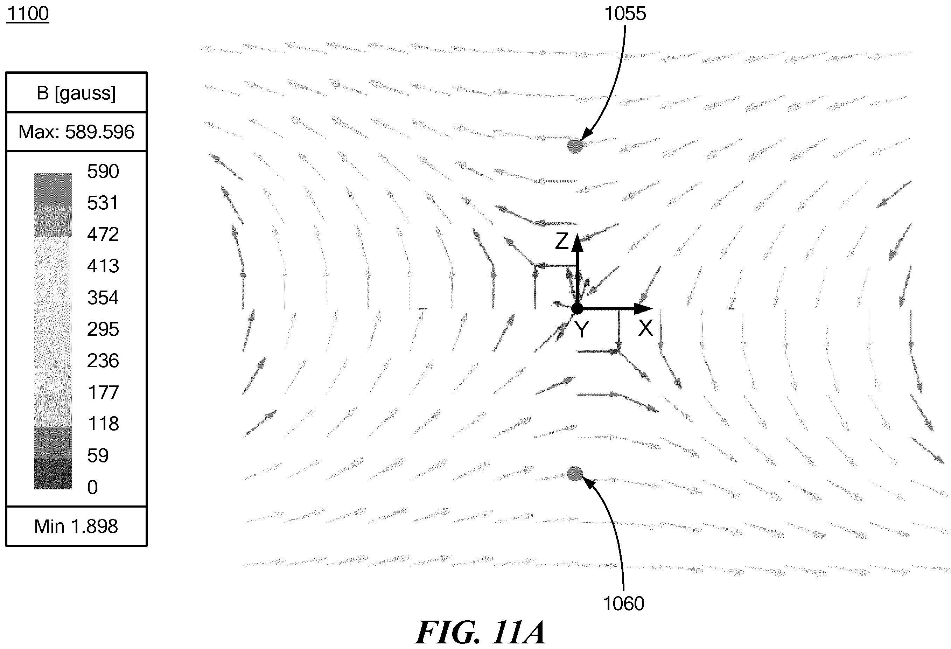

FIG. 11A is a graph 1100 with a plot of vectors representing a magnetic field in a plane around an example current sensor device (e.g., current sensor device 550) positioned in proximity to example conductor structure 810 of FIGs. 8A and 8B in an arrangement with conductors in proximity on either side of conductor structure 810. For example, graph 1100 represents the magnetic curl field generated by currents flowing through adjacent conductors around a current sensor device (e.g., current sensor device 953) positioned in a conductor structure (e.g., conductor structure 945) in an arrangement such as arrangement 940. Positions 1055 and 1060 represent positions of the magnetic field sensing elements, with the magnetic field sensing elements oriented so as to be maximally sensitive to a magnetic field along a Y-axis direction (e.g., toward the viewer). The plotted magnetic field vectors represent the magnetic curl field generated by currents flowing through adjacent conductor structures. Because the magnetic sensing elements are oriented so as to be maximally sensitive to a magnetic field along a Y-axis direction (facing the viewer), the magnetic field sensing elements at positions 1055 and 1060 may be mostly insensitive to the magnetic curl field generated by the currents flowing through the adjacent conductor structures.

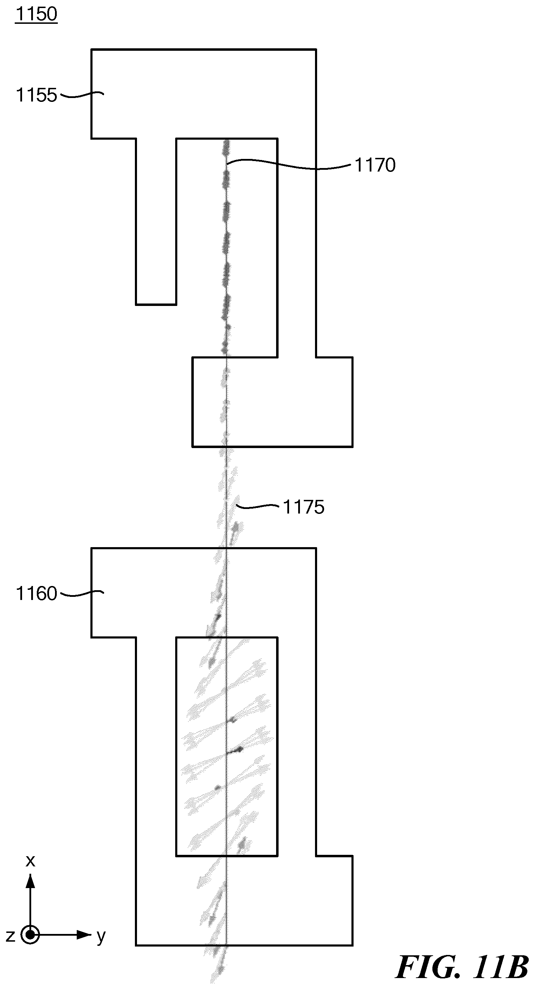

FIG. 11B is a diagram 1150 showing a plot 1175 representing a magnetic field in a Y-axis direction along a plane 1170 when current is flowing in one example conductor structure in an arrangement of example conductor structures. For example, 1160 may correspond to a cutaway portion of conductor structure 920 of FIG. 9B, and 1155 may correspond to a cutaway portion of conductor structure 915 of FIG. 9B. As shown in FIG. 11B, when current is flowing through conductor structure 920, a magnetic field is generated in the Y-axis direction by the current flowing through bridges 813, 814 of conductor structure 920. The strength of this magnetic field quickly dissipates in the X-axis direction, such that almost none of the magnetic field strength in the Y-axis direction is present at the hole of an adjacent conductor structure 915. Thus, conductor structures 915 and 920 may be packed closely together, and current sensor devices may positioned in the holes of the conductor structures with their magnetic field sensing elements oriented to be sensitive to the magnetic field along the Y-axis direction, with very little crosstalk impacting the current sensor devices.

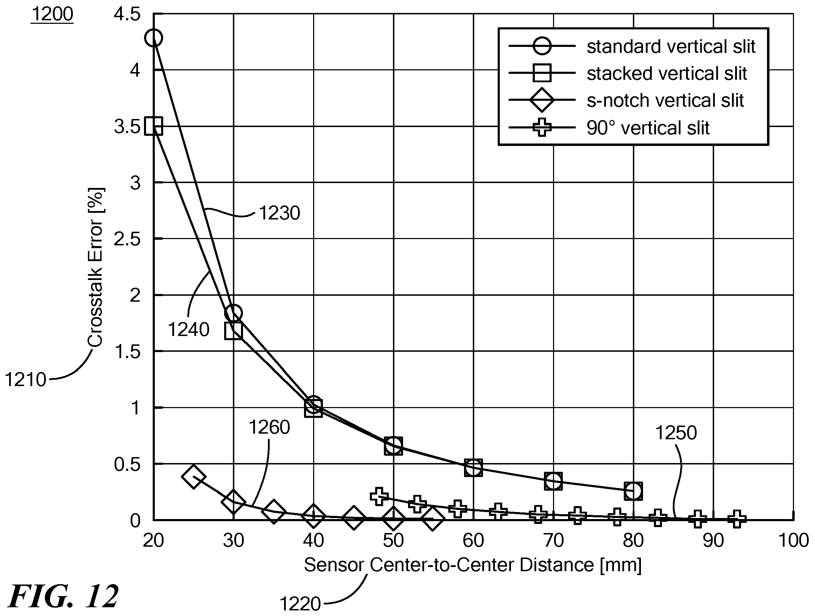

FIG. 12 is a graph 1200 showing cross-talk error associated with different systems using different example conductor structures discussed herein. Graph 1200 includes a Y-axis 1210 representing crosstalk error in percent, and an X-axis representing a center-to-center distance between current sensor devices in mm.

Plot 1230 represents the crosstalk error in a current sensor device when conductor structures are arranged in a standard vertical slit arrangement 600, as shown in FIG. 6A. The center-to-center distance corresponds to distance 630. As shown in FIG. 12, the error (in percent) in the current sensor device's current measurements attributable to crosstalk increases as the center-to-center distance in the arrangement decreases. That is, when a first current sensor device positioned in the hole of conductor structure 610 is 20 mm from a second current sensor device positioned in the hole of conductor structure 620, the first current sensor device's current measurements may be off by approximately 4.25% due to crosstalk. As the conductor structures are positioned further apart, the crosstalk error decreases. For example, when a first current sensor device positioned in the hole of conductor structure 610 is 80 mm from a second current sensor device positioned in the hole of conductor structure 620, the first current sensor device's current measurements may be off by about 0.25% due to crosstalk.

Plot 1240 represents the crosstalk error in a current sensor device when conductor structures are arranged in a stacked vertical slit arrangement 650, as shown in FIG. 6B. The center-to-center distance corresponds to distance 680. As shown in FIG. 12, the error (in percent) in the current sensor device's current measurements attributable to crosstalk increases as the center-to-center distance in the arrangement decreases. That is, when a first current sensor device positioned in the hole of conductor structure 660 is 20 mm from a second current sensor device positioned in the hole of conductor structure 670, the first current sensor device's current measurements may be off by about 3.5% due to crosstalk. As the conductor structures are positioned further apart, the crosstalk error decreases. For example, when a first current sensor device positioned in the hole of conductor structure 660 is 80 mm from a second current sensor device positioned in the hole of conductor structure 670, the first current sensor device's current measurements may be off by about 0.25% due to crosstalk.

Plot 1250 represents the crosstalk error in a current sensor device when conductor structures are arranged in a 90° vertical slit arrangement 700, as shown in FIG. 7. The center-to-center distance corresponds to distance 790. As shown in FIG. 12, the error (in percent) in the current sensor device's current measurements attributable to crosstalk increases as the center-to-center distance in the arrangement decreases. That is, when a first current sensor device positioned in the hole of conductor structure 750 is about 50 mm from a second current device positioned in the hole of conductor structure 710, the first current sensor device's current measurements may be off by about 0.25% due to crosstalk. As the conductor structures are positioned further apart, the crosstalk error decreases. For example, when a first current sensor device positioned in the hole of conductor structure 750 is about 80 mm from a second current sensor device positioned in the hole of conductor structure 710, the error in the first current sensor device's current measurements due to crosstalk may be very low (i.e., close to 0%). A center-to-center distance of less than about 45 mm is not included in plot 1250, because, as previously discussed, the conductor structures in the 90° vertical slit arrangement cannot be packed as closely together.

Plot 1260 represents the crosstalk error in a current sensor device when conductor structures are arranged in an S-notch vertical slit arrangement 910, as shown in FIG. 9B. The center-to-center distance corresponds to distance 935. As shown in FIG. 12, the error (in percent) in the current sensor device's current measurements attributable to crosstalk increases as the center-to-center distance in the arrangement decreases. That is, when a first current sensor device positioned in the hole of conductor structure 920 is about 25 mm from a second current sensor device positioned in the hole of conductor structure 915, the first current sensor device's current measurements may be off by about 0.4% due to crosstalk. As the conductor structures are positioned further apart, the crosstalk error decreases. For example, when a first current sensor device positioned in the hole of conductor structure 920 is about 55 mm from a second current sensor device positioned in the hole of conductor structure 915, the error in the first current sensor device's current measurements due to crosstalk may be very low (i.e., close to 0%).

Thus, as can be seen from the plots in FIG. 12, conductor structures and current sensor devices may be packed closely together in an S-notch vertical slit arrangement. For example, the conductor structures and current sensor devices may be packed much more closely together in an S-notch vertical slit arrangement than in a 90° vertical slit arrangement. Moreover, at a given center-to-center distance, current sensors positioned in holes of conductor structures in an S-notch vertical slit arrangement may experience much lower crosstalk error (e.g., approximately 0.4% error at 25 mm center-to-center distance) than current sensors positioned in holes of conductor structures in a standard vertical slit arrangement (e.g., approximately 3% error at 25 mm center-to-center distance) or current sensors positioned in holes of conductor structures in a stacked vertical slit arrangement (e.g., approximately 2.5% error at 25 mm center-to-center distance). Thus, systems utilizing the S-notch vertical slit arrangement may be advantageous over systems utilizing other arrangements, in that they reduce error due to current sensor device misplacement, allow the conductor structures and current sensor devices to be tightly packed (saving space in manufacturing a system), and reduce error in the current sensor devices due to crosstalk.

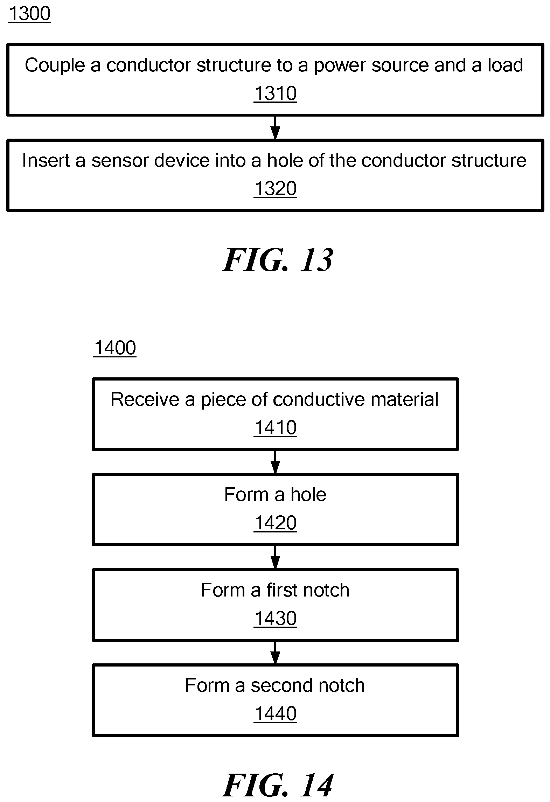

FIG. 13 is an example process 1300 for configuring a system including an example conductor structure and an example current sensor device, consistent with embodiments of the present disclosure. The conductor structure may be conductor structure 810, as previously discussed, though the disclosure is not so limited. The current sensor device may be current sensor device 550, though the disclosure is not so limited.

In 1310, a conductor structure (e.g., conductor structure 810) may be coupled to a power source (e.g., power source 102 of system 100 of FIG. 1) and to a load (e.g., load 104 of system 100 of FIG. 1). For example, conductive clamps or some other type of connection may be used to connect a conductor structure to the power source and the load. In some embodiments, the conductor structure may be coupled to the power source and load by coupling connectors to connection points, such as circular voids created in the conductor structure.

In 1320, a current sensor device (e.g., current sensor device 550) may be inserted into a hole of the conductor structure. For example, a current sensor device 550 may be inserted into a hole 830 of conductor structure 810. As previously discussed, the current sensor device may be positioned such that the magnetic field sensing elements of the current sensor device are maximally sensitive to the magnetic field along the lengthwise direction of the conductor structure (i.e., along a second dimension, or along or parallel to a Y-axis, as shown in FIG. 9A). That is, the current sensor device may be positioned in the hole of the conductor structure such that the magnetic field sensing elements are maximally sensitive to a magnetic field along the second dimension when current is flowing through the conductor structure.

One of skill in the art would recognize that steps 1310 and 1320 may be reversed in order, or may be performed simultaneously. In a system (e.g., system 100 of FIG. 1), the conductor structure and current sensor device may be fixed in place. For example, the conductor structure may be mounted in a position by bolts, screws, adhesives, or other fasteners. The current sensor device may be similarly mounted in a position within the hole of the conductor structure. In some embodiments, the current sensor device may be coupled to a PCB positioned proximate to the conductor structure. In some embodiments, coupling of the current sensor device to the PCB will function to fix the current sensor device in place. In some embodiments, the current sensor device may be fixed in position by a fastener, such as a screw or adhesive. A PCB and/or wires may be used to couple the current sensor device to a controller (e.g., controller 101 of system 100 of FIG. 1), such that current measurements taken by the current sensor device may be sent to the controller, and the controller may act upon the measurements to make adjustments to a power source (e.g., power source 102 of system 100 of FIG. 1) and/or to a load (e.g., load 104 of system 100 of FIG. 1). As previously discussed, placement of the current sensor device relative to the conductor structure may change due to vibration, temperature changes, or other fluctuations in a system. However, placement of the current sensor device in the hole of the conductor structure may reduce the impact of these misplacements on the current sensor device's current sensing accuracy.

Process 1300 may be repeated for additional conductor structures and additional current sensor devices. That is, in 1310 a second conductor structure may be coupled to a power source (e.g., power source 102 of system 100 of FIG. 1) and a load (e.g., load 104 of system 100 of FIG. 1). The second conductor structure may also be a conductor structure 810. In 1320, a second current sensor device may be inserted into a hole of the second conductor structure.

Process 1300 may be repeated for any number of conductor structures and current sensor devices. For example, in a three-phase power system, it may be desired to utilize three conductor structures and three current sensor devices, as previously discussed. For example, system 100 of FIG. 1 comprises three conductor structures 108A, 108B, 108C (each of which may be a conductor structure 810) and three current sensor devices (each of which may be a current sensor device 550). Of course, the disclosure is not limited to any particular number of conductor structures and current sensor devices. One of skill in the art would recognize that any N number of conductor structures and current sensor devices may be utilized in a system.

In some embodiments, 1310 may be performed simultaneously for multiple conductor structures and/or 1320 may be performed simultaneously for multiple current sensor devices.

FIG. 14 is an example process 1400 for making an example conductor structure, consistent with embodiments of the present disclosure. Process 1400 may be used, for example, to make conductor structure 810.

In 1410, a piece of conductive material may be received. As previously discussed, the conductor structure may be composed of copper, brass, aluminum, or any other type of conductive material. The conductor structure may alternatively be formed of a combination of different types of conductive materials, such as in layers or as an alloy. In some embodiments, the conductive material may be received in a form factor, such as a flat strip, solid bar, rod, or other form factor. In some embodiments, a form factor, such as a bar, may be stamped out of a larger piece of conductive material.

In 1420, a hole (e.g., hole 830) may be formed in the piece of conductive material. In some embodiments, the hole may be formed by cutting (or stamping out) material used to form the conductor structure. The hole may be formed by cutting (or stamping out) material having certain dimensions (e.g., a width, length, and thickness). In some embodiments, the hole may be formed by cutting (or stamping out) material all the way through a thickness of the conductive material.

In 1430, a first notch (e.g., notch 818) may be formed in the piece of conductive material. In some embodiments, the first notch may be formed by cutting (or stamping out) material used to form the conductor structure. The first notch may be formed by cutting (or stamping out) material having certain dimensions (e.g., a width, length, and thickness). In some embodiments, the first notch may be formed by cutting (or stamping out) material all the way through a thickness of the conductive material.

In 1440, a second notch (e.g., notch 823) may be formed in the piece of conductive material. In some embodiments, the second notch may be formed by cutting (or stamping out) material used to form the conductor structure. The second notch may be formed by cutting (or stamping out) material having certain dimensions (e.g., a width, length, and thickness). In some embodiments, the second notch may be formed by cutting (or stamping out) material all the way through a thickness of the conductive material.

In some embodiments, one or more connection points, such as the circular voids previously described, may also be formed in the piece of conductive material by cutting (or stamping out) the circular voids.

A person of ordinary skill in the art would recognize that, although shown as occurring in a certain order in FIG. 14, 1420, 1430, and 1440 may occur in any order, or simultaneously. Process 1400 may be repeated for any number of conductor structures. Alternatively, multiple conductor structures may be formed simultaneously be performing process 1400 simultaneously on one or more pieces of conductive material.

Although not described in detail herein, one of skill in the art would recognize that there are many known techniques for cutting, or stamping out, pieces of a material. Any of those known techniques should be considered to be within the scope of the disclosure herein as ways to cut or stamp out material.

In some embodiments, steps 1420, 1430, and 1440, rather than being performed by cutting or stamping out material, may be performed by melting a conductive material at a high temperature (such as in a furnace), and then pouring the molten conductive material into a mold, the mold thereby forming the hole, first notch, and second notch. The molten conductive material may then be cooled to produce the conductor structure.

Although the conductor structures and current sensor devices are described herein primarily in reference to electric vehicle systems, the disclosure is not so limited. The conductor structures and current sensor devices described herein may be utilized in any system for that provides current and measures the current provided. For example, the conductor structures and current sensor devices described herein may be widely applicable in electric motor systems in applications ranging from electric vehicles to industrial operations.

Although the current sensor devices described herein are primarily discussed as using Hall plate magnetic field sensing elements, the disclosure is not so limited. As previously discussed, any of a variety of different types of magnetic field sensing elements may be used. As one example, a current sensor device may be used with TMR magnetic field sensing elements. When a current sensor device using TMR magnetic field sensing elements is used, hole 830 of conductor structure 810 may be rotated by 90 degrees from what is shown in FIG. 9A, and the current sensor device may be rotated 90 degrees from what is shown in FIG. 9A when the current sensor device is positioned in the hole of the conductor structure. That is, the hole of the conductor structure would have a shape more similar to that shown in FIGs. 5A and 5B, and the current sensor device would be placed in the hole more similarly to what is shown in FIGs. 5A and 5B. Notches 818 and 823 of conductor structure 810 would be moved further apart to accommodate the 90 degree rotated hole. The reason for the rotation of the hole and current sensor device is that the TMR magnetic field sensing elements may be maximally sensitive to a magnetic field that is parallel to the magnetic field sensing elements, rather than perpendicular to the magnetic field sensing elements as in Hall plates magnetic field sensing elements. Thus, by rotating the hole by 90 degrees and rotating the current sensor device by 90 degrees, the TMR magnetic field sensing elements may be maximally sensitive to the magnetic field along the second dimension (e.g., along or parallel to a Y-axis), just like in the example current sensor device using Hall plate magnetic field sensing elements.

As used herein, the terms "processor" and "controller" are used to describe electronic circuitry that performs a function, an operation, or a sequence of operations. The function, operation, or sequence of operations can be hard coded into the electronic circuit or soft coded by way of instructions held in a memory device. The function, operation, or sequence of operations can be performed using digital values or using analog signals. In some embodiments, the processor or controller can be embodied in an application specific integrated circuit (ASIC), which can be an analog ASIC or a digital ASIC, in a microprocessor with associated program memory and/or in a discrete electronic circuit, which can be analog or digital. A processor or controller can contain internal processors or modules that perform portions of the function, operation, or sequence of operations. Similarly, a module can contain internal processors or internal modules that perform portions of the function, operation, or sequence of operations of the module.

While electronic circuits shown in figures herein may be shown in the form of analog blocks or digital blocks, it will be understood that the analog blocks can be replaced by digital blocks that perform the same or similar functions and the digital blocks can be replaced by analog blocks that perform the same or similar functions. Analog-to-digital or digital-to-analog conversions may not be explicitly shown in the figures but should be understood.

Various embodiments of the systems and methods are described herein with reference to the related drawings. Alternative embodiments can be devised without departing from the scope of the described concepts. It is noted that various connections and positional relationships (e.g., over, below, adjacent, etc.) are set forth between elements in the following description and in the drawings. These connections and/or positional relationships, unless specified otherwise, can be direct or indirect, and the present invention is not intended to be limiting in this respect. Accordingly, a coupling of entities can refer to either a direct or an indirect coupling, and a positional relationship between entities can be a direct or indirect positional relationship. As an example of an indirect positional relationship, references in the present description to element or structure A over element or structure B include situations in which one or more intermediate elements or structures (e.g., element C) is between elements A and B regardless of whether the characteristics and functionalities of elements A and/or B are substantially changed by the intermediate element(s).

Furthermore, it should be appreciated that relative, directional or reference terms (e.g. such as "above," "below," "left," "right," "top," "bottom," "vertical," "horizontal," "front," "back," "rearward," "forward," etc.) and derivatives thereof are used only to promote clarity in the description of the figures. Such terms are not intended as, and should not be construed as, limiting. Such terms may simply be used to facilitate discussion of the drawings and may be used, where applicable, to promote clarity of description when dealing with relative relationships, particularly with respect to the illustrated embodiments. Such terms are not, however, intended to imply absolute relationships, positions, and/or orientations. For example, with respect to an object or structure, an "upper" or "top" surface can become a "lower" or "bottom" surface simply by turning the object over. Nevertheless, it is still the same surface and the object remains the same. Also, as used herein, "and/or" means "and" or "or," as well as "and" and "or." Moreover, all patent and non-patent literature cited herein is hereby incorporated by references in their entirety.

The terms "disposed over," "overlying," "atop," "on top," "positioned on" or "positioned atop" mean that a first element, such as a first structure, is present on a second element, such as a second structure, where intervening elements or structures (such as an interface structure) may or may not be present between the first element and the second element. The term "direct contact" means that a first element, such as a first structure, and a second element, such as a second structure, are connected without any intermediary elements or structures between the interface of the two elements. The term "connection" can include an indirect connection and a direct connection.

It should be recognized that values described herein may be exact or approximate. One of ordinary skill in the art would recognize that values described herein may vary depending on, for example, manufacturing tolerances of components in sensor devices. As a result, values that deviate from a described value by up to +/- 20% of the described value may be deemed to correspond to the value described.

In the foregoing detailed description, various features are grouped together in one or more individual embodiments for the purpose of streamlining the disclosure. This method of disclosure is not to be interpreted as reflecting an intention that each claim requires more features than are expressly recited therein. Rather, inventive aspects may lie in less than all features of each disclosed embodiment.

References in the disclosure to "one embodiment," "an embodiment," "some embodiments," or variants of such phrases indicate that the embodiment(s) described can include a particular feature, structure, or characteristic, but every embodiment can include the particular feature, structure, or characteristic. Moreover, such phrases are not necessarily referring to the same embodiment(s). Further, when a particular feature, structure, or characteristic is described with reference to one embodiment, knowledge of one skilled in the art may be relied upon to affect such feature, structure, or characteristic in connection with other embodiments whether or not explicitly described.

The disclosed subject matter is not limited in its application to the details of construction and to the arrangements of the components set forth in the following description or illustrated in the drawings. The disclosed subject matter is capable of other embodiments and of being practiced and carried out in various ways. As such, those skilled in the art will appreciate that the conception, upon which this disclosure is based, may readily be utilized as a basis for the designing of other structures, methods, and systems for carrying out the several purposes of the disclosed subject matter. Therefore, the claims should be regarded as including such equivalent constructions insofar as they do not depart from the spirit and scope of the disclosed subject matter.

Although the disclosed subject matter has been described and illustrated in the foregoing exemplary embodiments, it is understood that the present disclosure has been made only by way of example, and that numerous changes in the details of implementation of the disclosed subject matter may be made without departing from the spirit and scope of the disclosed subject matter.
All publications and references cited herein are expressly incorporated herein by reference in their entirety.

**Claims**

1. A system comprising:

   a conductor structure having a width along a first dimension and a length longer than the width along a second dimension, the conductor structure comprising:

   a first portion of the conductor structure defining a hole passing through the conductor structure;
   a second portion of the conductor structure defining a first notch out of a first side of the conductor structure;
   a third portion of the conductor structure defining a second notch out of a second side of the conductor structure; and

   a sensor device positioned in the hole, the sensor device comprising first and second magnetic field sensing elements configured to be sensitive to a magnetic field along the second dimension when current flows through the conductor structure.

2. The system of claim 1, wherein at least one of the first and second magnetic field sensing elements is one of a Hall plate element or a tunneling magnetoresistance (TMR) element.

3. The system of claim 1, wherein the first and second magnetic field sensing elements are Hall plate elements.

4. The system of claim 1, wherein the hole is at least partially defined by a first edge of the first portion along the first dimension and a second edge of the first portion along the second dimension.

5. The system of claim 4, wherein the first edge is longer than the second edge.

6. The system of claim 1, wherein the first notch passes through the conductor structure.

7. The system of claim 1, wherein each of the first notch and the second notch passes through the conductor structure.

8. The system of claim 1, wherein the first notch is at least partially defined by a first edge of the second portion along the second dimension.

9. The system of claim 1, wherein the second notch is at least partially defined by a first edge of the third portion along the second dimension.

10. The system of claim 1, wherein the hole is at least partially defined by parallel bars of the conductor structure along the first dimension.

11. The system of claim 10, wherein the hole is at least partially defined by parallel bars of the conductor structure along the second dimension.

12. The system of claim 1, wherein the first portion, second portion, and third portion together form an S-shape.

13. The system of claim 1, wherein the conductor structure is a first conductor structure having a first width and a first length, and the sensor device is a first sensor device, further comprising:

    a second conductor structure having a second width along the first dimension and a second length along the second dimension, the second conductor structure defining a second hole passing through the second conductor structure; and
    a second sensor device positioned in the second hole.

14. The system of claim 13, further comprising:

    a third conductor structure having a third width along the first dimension and a third length along the second dimension, the third conductor structure defining a third hole passing through the third conductor structure; and
    a third sensor device positioned in the third hole.

15. The system of claim 13, wherein a first surface of the first conductor structure is parallel with a first surface of the second conductor structure.

16. The system of claim 14, wherein the first conductor structure is configured to transmit a first alternating current, the second conductor structure is configured to transmit a second alternating current that is phase-shifted from the first alternating current, and the third conductor structure is configured to transmit a third alternating current that is phase-shifted from the first alternating current and that is phase-shifted from the second alternating current.

17. The system of claim 1, wherein the conductor structure is a busbar.

18. A method of configuring a current sensor system, comprising:

coupling a conductor structure to a power source and a load, the conductor structure having a width along a first dimension and a length along a second dimension, the conductor structure further defining a hole passing through the conductor structure, a first notch out of a first side of the conductor structure, and a second notch out of a second side of the conductor structure; and

inserting a sensor device into the hole such that first and second magnetic field sensing elements of the sensor device are configured to be sensitive to a magnetic field along the second dimension when current is flowing through the conductor structure.

19. The method of claim 18, wherein the conductor structure is a first conductor structure, and the sensor device is a first sensor device, further comprising:

coupling a second conductor structure to the power source and the load, the second conductor structure having a hole passing through the second conductor structure, a first notch out of the side of the second conductor structure, and a second notch out of a second side of the second conductor structure; and

inserting a second sensor device into the hole of the second conductor structure such that first and second magnetic field sensing elements of the second sensor device are configured to be sensitive to a magnetic field along the second dimension when current is flowing through the second conductor structure.

20. A conductor structure having a width along a first dimension and a length longer than the width along a second dimension, the conductor structure comprising:

a first portion that defines a hole passing through the conductor structure, the hole being at least partially defined by a first edge along the first dimension and a second edge along the second dimension, the first edge being longer than the second edge;

a second portion defining a first notch out of a first side of the conductor structure; and

a third portion defining a second notch out of a second side of the conductor structure.

21. A method of making a conductor structure, comprising:

receiving a piece of conductive material;

forming a hole out of the conductive material;

forming a first notch out of the conductive material, the first notch being formed out of a first side of the conductive material; and

forming a second notch out of the conductive material, the second notch being formed out of a second side of the conductive material.

22. The method of claim 21, wherein the hole, first notch, and second notch are formed by stamping the hole, first notch, and second notch out of the piece of conductive material.

23. The method of claim 21, wherein the hole, first notch, and second notch are formed by melting the piece of conductive material and pouring the molten conductive material into a mold.

**FIG. 1**

200

**FIG. 2**

300

**FIG. 3**

**FIG. 4**

EP 4 707 821 A1

**FIG. 5A**

**FIG. 5B**

**FIG. 5C**

620

*600*

610

630

x

z    y

**FIG. 6A**

*650*    670

660

680

x

z    y

**FIG. 6B**

**FIG. 7**

**FIG. 8A**

**FIG. 8B**

880

848 885 860 854

850 852

810 857

846

847

x

z ⊙ → y

EP 4 707 821 A1

**FIG. 9A**

**FIG. 9B**

**FIG. 9C**

EP 4 707 821 A1

1000

**FIG. 10A**

1050

**FIG. 10B**

*FIG. 11A*

1150

1155

1170

1175

1160

x

z → y

*FIG. 11B*

FIG. 12

1300

Couple a conductor structure to a power source and a load
1310

Insert a sensor device into a hole of the conductor structure
1320

*FIG. 13*

1400

Receive a piece of conductive material
1410

Form a hole
1420

Form a first notch
1430

Form a second notch
1440

*FIG. 14*

# EUROPEAN SEARCH REPORT

**Application Number**

EP 25 19 7126

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 11 656 250 B2 (ALLEGRO MICROSYSTEMS LLC [US]) 23 May 2023 (2023-05-23) | 1-11, 13-23 | INV.<br>G01R15/20 |
| Y | * claims 1,13, 15, 19 *<br>* figures 4, 5A, 9A, 9B *<br>* paragraphs [0053], [0065] * | 12 | ADD.<br>G01R33/00<br>G01R33/07 |
| Y | US 2024/077521 A1 (KURIYAMA KENJI [JP]) 7 March 2024 (2024-03-07) | 12 | G01R33/09 |
| A | * claim 1 *<br>* figures 6,7 * | 1-11, 13-17 | |

**TECHNICAL FIELDS
SEARCHED      (IPC)**

G01R

The present search report has been drawn up for all claims

| Place of search | Date of completion of the search | Examiner |
|---|---|---|
| Munich | 22 January 2026 | Moulara, Guilhem |

**EP 4 707 821 A1**

## ANNEX TO THE EUROPEAN SEARCH REPORT
## ON EUROPEAN PATENT APPLICATION NO.

EP 25 19 7126

This annex lists the patent family members relating to the patent documents cited in the above-mentioned European search report.
The members are as contained in the European Patent Office EDP file on
The European Patent Office is in no way liable for these particulars which are merely given for the purpose of information.

22-01-2026

| Patent document cited in search report | | Publication date | Patent family member(s) | | Publication date |
|---|---|---|---|---|---|
| US 11656250 | B2 | 23-05-2023 | EP | 4392790 A1 | 03-07-2024 |
| | | | US | 2023071087 A1 | 09-03-2023 |
| | | | WO | 2023038725 A1 | 16-03-2023 |
| US 2024077521 | A1 | 07-03-2024 | NONE | | |

EPO FORM P0459

For more details about this annex : see Official Journal of the European Patent Office, No. 12/82

38